# EUROPEAN PATENT APPLICATION

(11) **EP 4 129 497 A1**
(43) Date of publication of application: **08.02.2023**
(21) Application number: 21780794.0
(22) Date of filing: 24.03.2021
(51) Int. Cl.: B06B 1/06, H04R 17/00, H01L 41/08, H01L 41/083, H01L 41/09, H01L 41/18, H01L 41/253, H01L 41/257

(54) **LAYERED PIEZOELECTRIC ELEMENT AND ELECTROACOUSTIC TRANSDUCER**

(30) Priority: 31.03.2020 JP 2020061719; 11.12.2020 JP 2020206068
(71) Applicant: FUJIFILM Corporation, Tokyo 106-8620 (JP)
(72) Inventor: ASHIKAWA, Teruo, Minamiashigara-shi, Kanagawa 250-0193 (JP); KAGAWA, Yusuke, Minamiashigara-shi, Kanagawa 250-0193 (JP); HIRAGUCHI, Kazuo, Minamiashigara-shi, Kanagawa 250-0193 (JP); MIYOSHI, Tetsu, Minamiashigara-shi, Kanagawa 250-0193 (JP)
(74) Representative: Klunker IP Patentanwälte PartG mbB
(86) International application number: PCT/JP2021/012200
(87) International publication number: WO 2021/200455

(57) **Abstract**

Provided is a laminated piezoelectric element is formed by folding back and laminating a piezoelectric film having an electrode layer and a protective layer on both sides of a piezoelectric layer in which piezoelectric particles are dispersed in a matrix. In the laminated two layers of the piezoelectric film, in a case where a thickness of a central portion thereof is a center thickness and a position up to twice the center thickness in a direction from the folded side end part toward the center is the folded-back portion, there is a position at which the thickness is greater than the center thickness in the folded-back portion, and there is an air gap in the folded-back portion or the air gap is filled with a cementing agent. The laminated piezoelectric element is able to prevent peeling of the electrode layer and the like in the folded-back portion in the laminated piezoelectric element in which the piezoelectric film is folded back and laminated. An electroacoustic transducer uses the laminated piezoelectric element.

## Description

### BACKGROUND OF THE INVENTION

### 1. Field of the Invention

The present invention relates to a laminated piezoelectric element used for an exciter or the like, and an electroacoustic transducer using the laminated piezoelectric element.

### 2. Description of the Related Art

A so-called exciter (exciton), which vibrates an article to generate sound in a case where the exciter is attached in contact with various articles, is used for various applications.

For example, in an office, by attaching an exciter to a conference table, a whiteboard, a screen, or the like during a presentation, a telephone conference, or the like, sound can be generated instead of a speaker. In a case of a vehicle such as an automobile, a guide sound, a warning sound, music, and the like can be sounded by attaching an exciter to the console, the A pillar, the ceiling, and the like. Further, in a case of a vehicle such as a hybrid vehicle and an electric vehicle that does not produce an engine sound, a vehicle approach notification sound can be emitted from the bumper or the like by attaching an exciter to the bumper or the like.

As a variable element that generates vibration in such an exciter, a combination of a coil and a magnet, a vibration motor such as an eccentric motor and a linear resonance motor, and the like have been known.

It is difficult for the variable elements to achieve reduction in thickness thereof. In particular, the vibration motor has disadvantages in that it is necessary to increase the mass in order to increase the vibration force, the response speed is slow to cause difficulty in frequency modulation for adjusting the degree of vibration, and so on.

As an exciter capable of solving such a problem, a laminated piezoelectric element in which a plurality of piezoelectric films formed by interposing a sheet-shaped piezoelectric layer between electrode layers and laminated is conceivable.

For example, JP2015-70110A describes a laminated piezoelectric element (piezoelectric device) used for an exciter or the like. The laminated piezoelectric element includes: a body portion of which the side surface is a bent portion formed by bending a piezoelectric film at least once in the direction of extension; a first reinforcing electrode that is formed on a side surface where the first electrode layer of the body portion is exposed; and a second reinforcing electrode that is formed on a side surface where a second electrode layer of the body portion is exposed. The piezoelectric film has a piezoelectric layer (piezoelectric film) extending in one direction, a first electrode layer (electrode film) provided on one surface of the piezoelectric layer, and a second electrode layer provided on the other surface of the piezoelectric layer.

### SUMMARY OF THE INVENTION

In many cases, it may be difficult to obtain sufficient piezoelectric characteristics with a single piezoelectric film. On the other hand, by laminating a plurality of layers of piezoelectric films, as described in JP2015-70110A, it is possible to improve the piezoelectric effect and obtain high piezoelectric performance.

Further, as in JP2015-70110A, the piezoelectric film is folded back to form a laminated structure in which a plurality of layers are laminated. Therefore, the production can be easily performed.

However, in the configuration in which the piezoelectric film is folded back to form a plurality of layers and laminated as described in JP2015-70110A, the outside of the piezoelectric film is in an extended state and the inside is in a contracted state in the folded-back portion.

Therefore, stress is applied to the electrode layer at the folded-back portion of the piezoelectric film, and damage such as breakage and peeling of the electrode layer occurs. In a case where the electrode layer is broken or peeled off, the relative permittivity of that part may change, resulting in inconveniences such as the inability to obtain the desired piezoelectric performance and the concentration of electric power to generate heat.

In order to solve such a problem of the prior art, an object of the present invention is to provide a laminated piezoelectric element capable of preventing damage such as peeling of an electrode layer in a folded-back portion, the laminated piezoelectric element having a plurality of layers of a piezoelectric film laminated by folding back a piezoelectric film having electrode layers on both sides of the piezoelectric layer, and an electroacoustic transducer using the laminated piezoelectric element.

In order to achieve such an object, the present invention has the following configurations.
[1] A laminated piezoelectric element formed by folding back and laminating a piezoelectric film having a piezoelectric layer including piezoelectric particles in a matrix including a polymer material, electrode layers provided on both sides of the piezoelectric layer, and a protective layer provided to cover the electrode layer,
   in which in adjacent two layers of the piezoelectric film folded back and laminated, in a case where a thickness of a central portion in a folding-back direction is a center thickness, a length from an end part of a folded-back portionto the central portion in the folding-back direction is L, and a region of 1/3 of the length L from the end part of the folded-back portion to the central portion in the folding-back direction is set as the folded-back portion, the folded-back portion has a part of which a thickness is greater than the center thickness, and
   an air gap is provided between adjacent two layers of the piezoelectric film in the folded-back portion, or a space between the adjacent two layers of the piezoelectric film is filled with a cementing agent.
[2] The laminated piezoelectric element according to [1], comprising a cementing layer to which adjacent two layers of the piezoelectric films folded back and laminated are cemented.
[3] The laminated piezoelectric element according to [1] or [2], in which the piezoelectric film is folded back and laminated a plurality of times.
[4] The laminated piezoelectric element according to any one of [1] to [3], in which positions of outer end parts of the folded-back portions adjacent in a lamination direction are different in the folding-back direction of the piezoelectric film.
[5] The laminated piezoelectric element according to any one of [1] to [4], in which the piezoelectric film is polarized in the thickness direction.
[6] The laminated piezoelectric element according to any one of [1] to [5], in which the polymer material of the piezoelectric layer is a polymer material having a cyanoethyl group.
[7] The laminated piezoelectric element according to [6], in which the polymer material is cyanoethylated polyvinyl alcohol.
[8] The laminated piezoelectric element according to any one of [1] to [7], comprising a protruding portion from which the piezoelectric film protrudes at an end part of the laminated piezoelectric element in a longitudinal direction,
   in which a length of the protruding portion in the longitudinal direction is 10% or more of a total length in the longitudinal direction.
[9] An electroacoustic transducer comprising: the laminated piezoelectric element according to any one of [1] to [8]; and a vibration plate to which the laminated piezoelectric element is fixed.
[10] The electroacoustic transducer according to [9], in which the vibration plate is flexible.
[11] The electroacoustic transducer according to [9] or [10], in which the vibration plate and the laminated piezoelectric element are cemented by a cementing agent.
[12] The electroacoustic transducer according to [11], in which the vibration plate has a quadrangular shape of which at least one group of two facing sides is fixed, and in a case where a distance between fixed ends of the two facing sides is L, cementing of the laminated piezoelectric element to the vibration plate is performed at positions separated from the fixed ends by "0.1 × L" or greater.
[13] The electroacoustic transducer according to [12], in which the vibration plate has a rectangular shape or a square shape.
[14] The electroacoustic transducer according to [12] or [13], in which a spring constant of the vibration plate is equal to or greater than 1 × 10⁴ and equal to or less than 1 × 10⁷ N/m.

According to the present invention, there are provided a laminated piezoelectric element capable of preventing damage such as peeling of an electrode layer in a folded-back portion, the laminated piezoelectric element having a plurality of layers of a piezoelectric film laminated by folding back a piezoelectric film, and an electroacoustic transducer using the laminated piezoelectric element.

### BRIEF DESCRIPTION OF THE DRAWINGS

Fig. 1 is a diagram conceptually showing an example of a laminated piezoelectric element of the present invention.
Fig. 2 is a diagram conceptually showing an example of a piezoelectric film that constitutes the laminated piezoelectric element shown in Fig. 1.
Fig. 3 is a conceptual diagram for describing an example of a production method of the piezoelectric film.
Fig. 4 is a conceptual diagram for describing an example of the production method of the piezoelectric film.
Fig. 5 is a conceptual diagram for describing an example of the production method of the piezoelectric film.
Fig. 6 is a conceptual diagram for describing an example of the laminated piezoelectric element of the present invention.
Fig. 7 is a conceptual diagram for describing another example of the laminated piezoelectric element of the present invention.
Fig. 8 is a conceptual diagram for describing another example of the laminated piezoelectric element of the present invention.
Fig. 9 is a diagram conceptually showing an example of a method of manufacturing the laminated piezoelectric element shown in Fig. 6.
Fig. 10 is a diagram conceptually showing an example of a method of manufacturing the laminated piezoelectric element shown in Fig. 7.
Fig. 11 is a diagram conceptually showing another example of the laminated piezoelectric element of the present invention.
Fig. 12 is a diagram conceptually showing an example of the electroacoustic transducer of the present invention.
Fig. 13 is a diagram conceptually showing another example of the laminated piezoelectric element of the present invention.
Fig. 14 is a conceptual diagram for describing a sound pressure measuring method in an example.
Fig. 15 is a conceptual diagram for describing the sound pressure measuring method in the example.
Fig. 16 is a diagram conceptually showing another example of the laminated piezoelectric element of the present invention.
Fig. 17 is a diagram conceptually showing another example of the laminated piezoelectric element of the present invention.
Fig. 18 is a conceptual diagram for describing a protruding portion of the laminated piezoelectric element of the present invention.
Fig. 19 is a diagram conceptually showing another example of the laminated piezoelectric element of the present invention.
Fig. 20 is a diagram conceptually showing an example of a piezoelectric film included in the laminated piezoelectric element shown in Fig. 19.
Fig. 21 is a diagram conceptually showing another example of the laminated piezoelectric element of the present invention.
Fig. 22 is a diagram conceptually showing another example of the electroacoustic transducer of the present invention.
Fig. 23 is a diagram conceptually showing another example of the electroacoustic transducer of the present invention.
Fig. 24 is a diagram conceptually showing another example of the electroacoustic transducer of the present invention.
Fig. 25 is a diagram conceptually showing another example of the electroacoustic transducer of the present invention.
Fig. 26 is a simulation result of vibration of a vibration plate by an electroacoustic transducer using the laminated piezoelectric element in which four layers of the piezoelectric film 12 shown in Fig. 2 are laminated.
Fig. 27 is a conceptual diagram for describing Fig. 26.
Fig. 28 is a conceptual diagram for describing another example of the electroacoustic transducer of the present invention.
Fig. 29 is a conceptual diagram for describing another example of the electroacoustic transducer of the present invention.
Fig. 30 is a conceptual diagram for describing another example of the electroacoustic transducer of the present invention.

### DESCRIPTION OF THE PREFERRED EMBODIMENTS

Hereinafter, the laminated piezoelectric element and the electroacoustic transducer of the present invention will be described in detail on the basis of the preferred embodiments shown in the accompanying drawings.

Descriptions of the configuration requirements described below may be made on the basis of representative embodiments of the present invention, but the present invention is not limited to such embodiments.

In the present specification, a numerical range expressed using "to" means a range including numerical values described before and after "to" as a lower limit and an upper limit.

Further, the drawings shown below are conceptual diagrams for describing the present invention. Accordingly, the thickness, size, shape, positional relationship, and the like of each component are not necessarily the same as the actual ones.

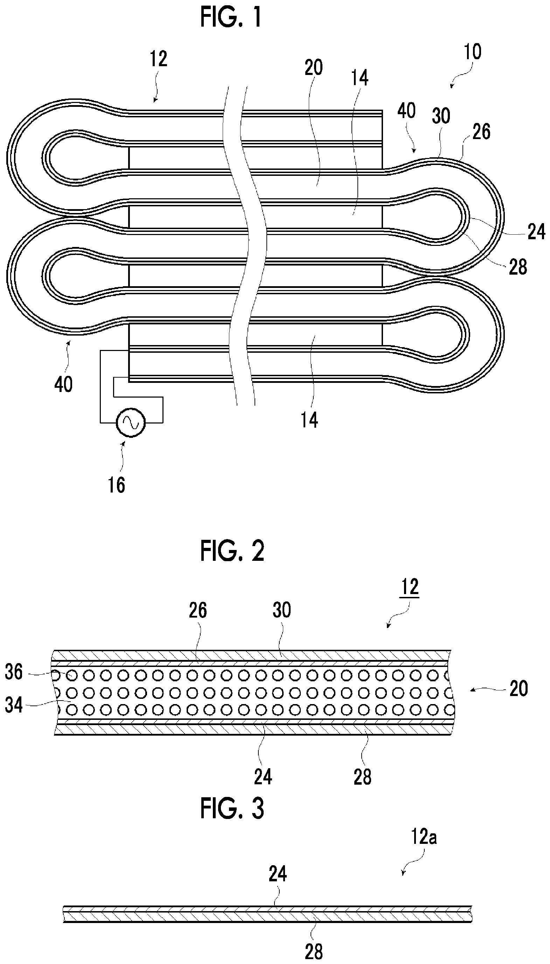

Fig. 1 conceptually shows an example of the laminated piezoelectric element of the present invention.

The laminated piezoelectric element 10 shown in Fig. 1 is made in a state in which one piezoelectric film 12 is folded back four times to form a state in which five layers of a piezoelectric film 12 are laminated. The piezoelectric film 12 has electrode layers 24 and 26 on both sides of a piezoelectric layer 20, covers both electrode layers 24 and 26, and has protective layers 28 and 30.

As will be described in detail later, in the laminated piezoelectric element 10 of the present invention, in the laminated piezoelectric element in which the piezoelectric film 12 is folded back and laminated in a bellows shape, the folded-back portion 40 of the piezoelectric film 12 has a part that is thicker than the central portion. Further, the folded-back portion 40 has an air gap or is filled with a cementing agent.

With such a configuration, the laminated piezoelectric element 10 of the present invention prevents peeling of the electrode layer and the protective layer at the folded-back portion 40.

The laminated piezoelectric element 10 shown in Fig. 1 has five layers of the piezoelectric film 12 laminated by folding back the piezoelectric film 12 four times, but the present invention is not limited to this.

That is, the laminated piezoelectric element of the present invention may be a laminated piezoelectric film 12 having 2 to 4 layers by folding back the piezoelectric film 12 three times or less. Alternatively, the laminated piezoelectric element of the present invention may be one in which six or more layers of the piezoelectric film 12 are laminated by folding back the piezoelectric film five times or more.

The laminated piezoelectric element of the present invention preferably has three or more layers of the piezoelectric film 12 laminated by folding back the piezoelectric film 12 twice or more.

Further, the laminated piezoelectric element of the present invention may be a laminate of a plurality of laminated piezoelectric elements obtained by folding back the piezoelectric film 12 once or more.

Fig. 2 conceptually shows a piezoelectric film 12 in a cross-sectional view.

As shown in Fig. 2, the piezoelectric film 12 has the piezoelectric layer 20 which is a sheet-like member having piezoelectric characteristics, the first thin film electrode 24 laminated on one surface of the piezoelectric layer 20, the first protective layer 28 laminated on the first thin film electrode 24, the second thin film electrode 26 laminated on the other surface of the piezoelectric layer 20, and the second protective layer 30 laminated on the second thin film electrode 26. As will be described later, the piezoelectric film 12 is polarized in a thickness direction.

In the piezoelectric film 12, as a preferable aspect, as conceptually shown in Fig. 2, the piezoelectric layer 20 consists of a polymer-based piezoelectric composite material in which piezoelectric particles 36 are dispersed in a matrix 34 including a polymer material. The matrix 34 preferably includes a polymer material having viscoelasticity at room temperature, and more preferably consisting of a polymer material having viscoelasticity at room temperature. That is, it is preferable that the matrix 34 is a viscoelastic matrix having viscoelasticity at room temperature.

In the present invention, the term "room temperature" refers to a temperature range of about 0 to 50° C.

Here, it is preferable that the polymer-based piezoelectric composite material (the piezoelectric layer 20) has the following requisites.

### (i) Flexibility

For example, in a case of being gripped in a state of being loosely bent like a newspaper or a magazine as a portable device, the polymer-based piezoelectric composite material is continuously subjected to large bending deformation from the outside at a comparatively slow vibration of equal to or less than a few Hz. At this time, in a case where the polymer-based piezoelectric composite material is hard, large bending stress is generated to that extent, and a crack is generated at the interface between the polymer matrix and the piezoelectric particles, possibly leading to breakage. Accordingly, the polymer-based piezoelectric composite material is required to have suitable flexibility. In addition, in a case where strain energy is diffused into the outside as heat, the stress is able to be relieved. Accordingly, the loss tangent of the polymer-based piezoelectric composite material is required to be suitably large.

As described above, a flexible polymer-based piezoelectric composite material used as an exciter is required to be rigid with respect to vibration of 20 Hz to 20 kHz, and be flexible with respect to vibration of equal to or less than a few Hz. In addition, the loss tangent of the polymer-based piezoelectric composite material is required to be suitably large with respect to the vibration of all frequencies of equal to or less than 20 kHz.

Furthermore, it is preferable that the spring constant can be easily adjusted by lamination in accordance with the rigidity (hardness, stiffness, spring constant) of the mating material (vibration plate) to be cemented. At that time, as will be described later in detail, the thinner the cementing layer 14 shown in Fig. 1 is, the higher energy efficiency can be.

Generally, a polymer solid has a viscoelasticity relieving mechanism, and a molecular movement having a large scale is observed as a decrease (relief) in a storage elastic modulus (Young's modulus) or the local maximum (absorption) in a loss elastic modulus along with an increase in a temperature or a decrease in a frequency. Among them, the relief due to a microbrown movement of a molecular chain in an amorphous region is referred to as main dispersion, and an extremely large relieving phenomenon is observed. A temperature at which this main dispersion occurs is a glass transition point (Tg), and the viscoelasticity relieving mechanism is most remarkably observed.

In the polymer-based piezoelectric composite material (the piezoelectric layer 20), the polymer material of which the glass transition point is room temperature, in other words, the polymer material having viscoelasticity at room temperature is used in the matrix, and thus the polymer-based piezoelectric composite material which is rigid with respect to vibration of 20 Hz to 20 kHz and is flexible with respect to vibration of equal to or less than a few Hz is realized. Particularly, from a viewpoint of suitably exhibiting such behavior, it is preferable that a polymer material of which the glass transition point at a frequency of 1 Hz is room temperature, that is, equal to or greater than 0°C and equal to or less than 50°C is used in the matrix of the polymer-based piezoelectric composite material.

As the polymer material having viscoelasticity at room temperature, various known materials are able to be used. Preferably, a polymer material of which the local maximum value of a loss tangent Tanδ at a frequency of 1 Hz at room temperature, that is, equal to or greater than 0°C and equal to or less than 50°C in a dynamic viscoelasticity test is greater than or equal to 0.5 is used.

Accordingly, in a case where the polymer-based piezoelectric composite material is slowly bent due to an external force, stress concentration on the interface between the polymer matrix and the piezoelectric particles at the maximum bending moment portion is relieved, and thus high flexibility is able to be expected.

Further, it is preferable that, in the polymer material having viscoelasticity at room temperature, a storage elastic modulus (E') at a frequency of 1 Hz in accordance with dynamic viscoelasticity measurement is equal to or greater than 100 MPa at 0°C and is equal to or less than 10 MPa at 50°C.

Accordingly, it is possible to reduce a bending moment which is generated in a case where the polymer-based piezoelectric composite material is slowly bent due to the external force, and it is possible to make the polymer-based piezoelectric composite material rigid with respect to acoustic vibration of 20 Hz to 20 kHz.

In addition, it is more suitable that the relative permittivity of the polymer material having viscoelasticity at room temperature is greater than or equal to 10 at 25°C. Accordingly, in a case where a voltage is applied to the polymer-based piezoelectric composite material, a higher electric field is applied to the piezoelectric particles in the polymer matrix, and thus a large deformation amount is able to be expected.

However, in consideration of ensuring favorable moisture resistance or the like, it is suitable that the relative permittivity of the polymer material is equal to or less than 10 at 25°C.

As the polymer material having viscoelasticity at room temperature and satisfying such conditions, cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, polybutyl methacrylate, and the like are exemplified. In addition, as these polymer materials, a commercially available product such as Hybrar 5127 (manufactured by Kuraray Co., Ltd.) is also able to be suitably used. Among them, as the polymer material, a material having a cyanoethyl group is preferably used, and cyanoethylated PVA is particularly preferably used.

Furthermore, only one of these polymer materials may be used, or a plurality of types thereof may be used in combination (mixture).

The matrix 34 using such a polymer material having viscoelasticity at room temperature, as necessary, may use a plurality of polymer materials in combination.

That is, in order to control dielectric properties or mechanical properties, other dielectric polymer materials may be added to the matrix 34 in addition to a polymer material having viscoelasticity at room temperature such as cyanoethylated PVA, as necessary.

As the dielectric polymer material which is able to be added to the viscoelastic matrix, for example, a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, and a polyvinylidene fluoride-tetrafluoroethylene copolymer, a polymer having a cyano group or a cyanoethyl group such as a vinylidene cyanide-vinyl acetate copolymer, cyanoethyl cellulose, cyanoethyl hydroxy saccharose, cyanoethyl hydroxy cellulose, cyanoethyl hydroxy pullulan, cyanoethyl methacrylate, cyanoethyl acrylate, cyanoethyl hydroxy ethyl cellulose, cyanoethyl amylose, cyanoethyl hydroxy propyl cellulose, cyanoethyl dihydroxy propyl cellulose, cyanoethyl hydroxy propyl amylose, cyanoethyl polyacryl amide, cyanoethyl polyacrylate, cyanoethyl pullulan, cyanoethyl polyhydroxy methylene, cyanoethyl glycidol pullulan, cyanoethyl saccharose, and cyanoethyl sorbitol, and a synthetic rubber such as nitrile rubber or chloroprene rubber are exemplified.

Among them, a polymer material having a cyanoethyl group is suitably used.

Furthermore, the dielectric polymer added to the matrix 34 of the piezoelectric layer 20 in addition to the material having viscoelasticity at room temperature such as cyanoethylated PVA is not limited to one dielectric polymer, and a plurality of dielectric polymers may be added.

In addition, for the purpose of controlling the glass transition point Tg, a thermoplastic resin such as a vinyl chloride resin, polyethylene, polystyrene, a methacrylic resin, polybutene, and isobutylene, and a thermosetting resin such as a phenol resin, a urea resin, a melamine resin, an alkyd resin, or mica may be added to the matrix 34 in addition to the dielectric polymer material.

Furthermore, for the purpose of improving pressure sensitive adhesiveness, a viscosity imparting agent such as rosin ester, rosin, terpene, terpene phenol, and a petroleum resin may be added.

The amount of materials added to the matrix 34 of the piezoelectric layer 20 in a case where materials other than the polymer material having viscoelasticity at room temperature such as cyanoethylated PVA is not particularly limited, and it is preferable that a ratio of the added materials to the matrix 34 is equal to or less than 30 mass%.

Accordingly, it is possible to exhibit properties of the polymer material to be added without impairing the viscoelasticity relieving mechanism of the matrix 34, and thus a preferable result is able to be obtained from a viewpoint of increasing a dielectric constant, of improving heat resistance, and of improving adhesiveness between the piezoelectric particles 36 and the electrode layer.

The piezoelectric particles 36 consist of ceramics particles having a perovskite type or wurtzite type crystal structure.

As the ceramics particles forming the piezoelectric particles 36, for example, lead zirconate titanate (PZT), lead lanthanum zirconate titanate (PLZT), barium titanate (BaTiO₃), zinc oxide (ZnO), and a solid solution (BFBT) of barium titanate and bismuth ferrite (BiFes) are exemplified.

The particle diameter of the piezoelectric particles 36 is not limited, and may be appropriately selected depending on the size of the piezoelectric film 12 and the usage of the laminated piezoelectric element 10. The particle diameter of the piezoelectric particles 36 is preferably equal to or greater than 1 µm and equal to or less than 10 µm.

By setting the particle diameter of the piezoelectric particles 36 to be in the range described above, a preferable result is able to be obtained from a viewpoint of allowing the piezoelectric film 12 to achieve both high piezoelectric characteristics and flexibility.

In addition, in Fig. 2, the piezoelectric particles 36 in the piezoelectric layer 20 are uniformly dispersed in the matrix 34 with regularity. However, the present invention is not limited thereto.

That is, in the matrix 34, it is preferable that the piezoelectric particles 36 in the piezoelectric layer 20 are uniformly dispersed, and may also be irregularly dispersed.

Further, the piezoelectric particles 36 may have the same particle diameter or does not have to have the same particle diameter.

In the piezoelectric film 12, a quantitative ratio of the matrix 34 and the piezoelectric particles 36 in the piezoelectric layer 20 is not limited, and may be appropriately set in accordance with the size in the plane direction or the thickness of the piezoelectric film 12, the usage of the laminated piezoelectric element 10, properties required for the piezoelectric film 12, and the like.

The volume fraction of the piezoelectric particles 36 in the piezoelectric layer 20 is set to preferably equal to or greater than 30% and equal to or less than 80%, more preferably equal to or greater than 50%, and therefore even more preferably equal to or greater than 50% and equal to or less than 80%.

By setting the quantitative ratio of the matrix 34 and the piezoelectric particles 36 to be in the range described above, it is possible to obtain a preferable result from a viewpoint of making high piezoelectric characteristics and flexibility compatible.

In the piezoelectric film 12, the thickness of the piezoelectric layer 20 is not particularly limited, and may be appropriately set in accordance with the usage of the laminated piezoelectric element 10, the number of laminated piezoelectric films in the laminated piezoelectric element 10, properties required for the piezoelectric film 12, and the like.

The thicker the piezoelectric layer 20, the more advantageous it is in terms of rigidity such as the stiffness of a so-called sheet-like member, but the voltage (potential difference) required to stretch and contract the piezoelectric film 12 by the same amount increases.

The thickness of the piezoelectric layer 20 is preferably equal to or greater than 8 µm and equal to or less than 300 µm, more preferably equal to or greater than 8 µm and equal to or less than 200 µm, even more preferably equal to or greater than 10 µm and equal to or less than 150 µm, and particularly preferably equal to or greater than 15 and equal to or less than 100 µm.

By setting the thickness of the piezoelectric layer 20 to be in the range described above, it is possible to obtain a preferable result from a viewpoint of compatibility between ensuring the rigidity and appropriate flexibility, or the like.

The piezoelectric layer 20 is preferably subjected to polarization processing (poling) in the thickness direction. The polarization processing will be described in detail later.

As shown in Fig. 2, the piezoelectric film 12 in the shown example has a configuration in which the first thin film electrode 24 is provided on one surface of the piezoelectric layer 20, the first protective layer 28 is provided on the surface thereof, the second thin film electrode 26 is provided on the other surface of the piezoelectric layer 20, and the second protective layer 30 is provided on the surface thereof. Here, the first thin film electrode 24 and the second thin film electrode 26 form an electrode pair.

As shown in Fig. 1, in addition to the layers, the piezoelectric film 12 has, for example, an electrode lead-out portion for leading out the electrodes from the first thin film electrode 24 and the second thin film electrode 26, and the electrode lead-out portion is connected to a power source 16. Further, the piezoelectric film 12 may have an insulating layer or the like that covers a region where the piezoelectric layer 20 is exposed to prevent a short circuit or the like.

That is, the piezoelectric film 12 has a configuration in which both surfaces of the piezoelectric layer 20 are interposed between the electrode pair, that is, the first thin film electrode 24 and the second thin film electrode 26 and the laminate is further interposed between the first protective layer 28 and the second protective layer 30.

As described above, in the piezoelectric film 12, the region interposed between the first thin film electrode 24 and the second thin film electrode 26 is stretched and contracted according to an applied voltage.

In addition, in the present invention, the terms "first and second" in the first thin film electrode 24 and the first protective layer 28 and the second thin film electrode 26 and the second protective layer 30 are named in accordance with the drawing for convenience in order to explain the piezoelectric film 12. Accordingly, the first and second piezoelectric films 12 have no technical meaning and are irrelevant to the actual usage state.

In the piezoelectric film 12, the first protective layer 28 and the second protective layer 30 have a function of covering the first thin film electrode 24 and the second thin film electrode 26 and applying appropriate rigidity and mechanical strength to the piezoelectric layer 20. That is, there may be a case where, in the piezoelectric film 12, the piezoelectric layer 20 consisting of the matrix 34 and the piezoelectric particles 36 exhibits extremely superior flexibility under bending deformation at slow vibration but has insufficient rigidity or mechanical strength depending on the usage. As a compensation for this, the piezoelectric film 12 is provided with the first protective layer 28 and the second protective layer 30.

The first protective layer 28 and the second protective layer 30 are not limited, and may use various sheet-like members. For example, various resin films are suitably exemplified.

Among them, by the reason of excellent mechanical properties and heat resistance, a resin film consisting of polyethylene terephthalate (PET), polypropylene (PP), polystyrene (PS), polycarbonate (PC), polyphenylene sulfite (PPS), polymethyl methacrylate (PMMA), polyetherimide (PEI), polyimide (PI), polyethylene naphthalate (PEN), triacetylcellulose (TAC), or a cyclic olefin-based resin is suitably used.

There is no limitation on the thicknesses of the first protective layer 28 and the second protective layer 30. In addition, the thicknesses of the first protective layer 28 and the second protective layer 30 may basically be identical to each other or different from each other from each other.

Here, in a case where the rigidity of the first protective layer 28 and the second protective layer 30 is excessively high, not only is the stretching and contracting of the piezoelectric layer 20 constrained, but also the flexibility is impaired. Therefore, there is an advantage in a case where the thicknesses of first protective layer 28 and the second protective layer 30 are smaller unless mechanical strength or favorable handleability as a sheet-like member is required.

In the piezoelectric film 12, in a case where the thickness of the first protective layer 28 and the second protective layer 30 is equal to or less than twice the thickness of the piezoelectric layer 20, it is possible to obtain a preferable result from a viewpoint of compatibility between ensuring the rigidity and appropriate flexibility, or the like.

For example, in a case where the thickness of the piezoelectric layer 20 is 50 µm and the first protective layer 28 and the second protective layer 30 consist of PET, the thickness of the second protective layer 30 and the first protective layer 28 is preferably equal to or less than 100 µm, more preferably equal to or less than 50 µm, and even more preferably equal to or less than 25 µm.

In the piezoelectric film 12, the first thin film electrode 24 is formed between the piezoelectric layer 20 and the first protective layer 28, and the second thin film electrode 26 is formed between the piezoelectric layer 20 and the second protective layer 30. In the following description, the first thin film electrode 24 is also referred to as a first electrode 24, and the second thin film electrode 26 is also referred to as a second electrode 26.

The first electrode 24 and the second electrode 26 are provided to apply a voltage to the piezoelectric layer 20 (the piezoelectric film 12).

In the present invention, a forming material of the first electrode 24 and the second electrode 26 is not limited, and as the forming material, various conductive bodies are able to be used. Specifically, metals such as carbon, palladium, iron, tin, aluminum, nickel, platinum, gold, silver, copper, titanium, chromium, and molybdenum, alloys thereof, laminates and composites of these metals and alloys, indium-tin oxide, and the like are exemplified. Among them, copper, aluminum, gold, silver, platinum, and indium-tin oxide are suitably exemplified as the first electrode 24 and the second electrode 26.

In addition, a forming method of the first electrode 24 and the second electrode 26 is not limited, and various known methods such as a vapor-phase deposition method (a vacuum film forming method) such as vacuum vapor deposition or sputtering, film formation using plating, and a method of cementing a foil formed of the materials described above are able to be used.

Among them, in particular, by the reason that the flexibility of the piezoelectric film 12 is able to be ensured, a thin film made of copper, aluminum, or the like formed by using the vacuum vapor deposition is suitably used as the first electrode 24 and the second electrode 26. Among them, in particular, the copper thin film formed by using the vacuum vapor deposition is suitably used.

There is no limitation on thicknesses of the first electrode 24 and the second electrode 26. In addition, the thicknesses of the first electrode 24 and the second electrode 26 are basically the same, but may be different.

Here, similarly to the first protective layer 28 and second protective layer 30 mentioned above, in a case where the rigidity of the first electrode 24 and the second electrode 26 is excessively high, not only is the stretching and contracting of the piezoelectric layer 20 constrained, but also the flexibility is impaired. Therefore, there is an advantage in a case where the thicknesses of first electrode 24 and the second electrode 26 are smaller as long as electrical resistance is not excessively high.

In the piezoelectric film 12, in a case where the product of the thicknesses of the first electrode 24 and the second electrode 26 and the Young's modulus is less than the product of the thicknesses of the first protective layer 28 and the second protective layer 30 and the Young's modulus, the flexibility is not considerably impaired, which is suitable.

For example, in a case of a combination consisting of the first protective layer 28 and the second protective layer 30 formed of PET (Young's modulus: approximately 6.2 GPa) and the first electrode 24 and the second electrode 26 formed of copper (Young's modulus: approximately 130 GPa), in a case where the thickness of the first protective layer 28 and the second protective layer 30 is 25 µm, the thickness of the second electrode 26 and the first electrode 24 is preferably equal to or less than 1.2 µm, more preferably equal to or less than 0.3 µm, and particularly preferably equal to or less than 0.1 µm.

As described above, the piezoelectric film 12 has a configuration in which the piezoelectric layer 20 in which the piezoelectric particles 36 are dispersed in the matrix 34 containing the polymer material having viscoelasticity at room temperature is interposed between the first electrode 24 and the second electrode 26 and the laminate is interposed between the first protective layer 28 and the second protective layer 30.

In the piezoelectric film 12, it is preferable that the local maximum value of the loss tangent (Tanδ) at a frequency of 1 Hz in accordance with the dynamic viscoelasticity measurement exists at room temperature, and it is more preferable that a local maximum value of greater than or equal to 0.1 exists at room temperature.

Accordingly, even in a case where the piezoelectric film 12 is subjected to large bending deformation from the outside at a comparatively slow vibration of equal to or less than a few Hz, it is possible to effectively diffuse the strain energy to the outside as heat, and thus it is possible to prevent a crack from being generated on the interface between the polymer matrix and the piezoelectric particles.

In the piezoelectric film 12, it is preferable that the storage elastic modulus (E') at a frequency of 1 Hz in accordance with the dynamic viscoelasticity measurement is 10 to 30 GPa at 0°C, and 1 to 10 GPa at 50°C.

Accordingly, the piezoelectric film 12 is able to have large frequency dispersion in the storage elastic modulus (E') at room temperature. That is, the piezoelectric film 12 is able to be rigid with respect to vibration equal to or greater than 20 Hz and equal to or less than 20 kHz, and is able to be flexible with respect to vibration of equal to or less than a few Hz.

In addition, in the piezoelectric film 12, it is preferable that the product of the thickness and the storage elastic modulus (E') at a frequency of 1 Hz in accordance with the dynamic viscoelasticity measurement is 1.0 × 10⁶ to 2.0 × 10⁶ N/m at 0°C, and 1.0 × 10⁵ to 1.0 × 10⁶ N/m at 50°C.

Accordingly, the piezoelectric film 12 is able to have appropriate rigidity and mechanical strength within a range not impairing the flexibility and the acoustic properties.

Furthermore, in the piezoelectric film 12, it is preferable that the loss tangent (Tanδ) at a frequency of 1 kHz at 25°C is greater than or equal to 0.05 in a master curve obtained by the dynamic viscoelasticity measurement.

Accordingly, the frequency properties of a speaker using the piezoelectric film 12 are smoothened, and thus it is also possible to decrease the changed amount of acoustic quality in a case where the lowest resonance frequency f₀ is changed in accordance with a change in the curvature of the speaker.

Next, an example of the method of manufacturing the piezoelectric film 12 shown in Fig. 2 will be described with reference to the conceptual diagrams of Figs. 3 to 5.

First, as shown in Fig. 3, a sheet-like member 12a is provided in which the first electrode 24 is formed on the first protective layer 28. The sheet-like member 12a may be produced by forming a copper thin film or the like as the first electrode 24 on the surface of the first protective layer 28 using vacuum vapor deposition, sputtering, plating, or the like.

In a case where the first protective layer 28 is extremely thin, and thus the handleability is degraded, the first protective layer 28 with a separator (temporary support) may be used as necessary. As the separator, a PET film having a thickness of 25 to 100 µm, and the like are able to be used. The separator may be removed after thermal compression bonding of the second electrode 26 and the second protective layer 30 and before laminating any member on the first protective layer 28.

On the other hand, a coating material is provided by dissolving a polymer material having viscoelasticity at room temperature, such as cyanoethylated PVA, in an organic solvent, further adding the piezoelectric particles 36 such as PZT particles thereto, and stirring and dispersing the resultant. In the following description, the polymer material having viscoelasticity at room temperature, such as cyanoethylated PVA, is also referred to as a "viscoelastic material".

The organic solvent is not limited, and various organic solvents such as dimethylformamide (DMF), methyl ethyl ketone, and cyclohexanone are able to be used.

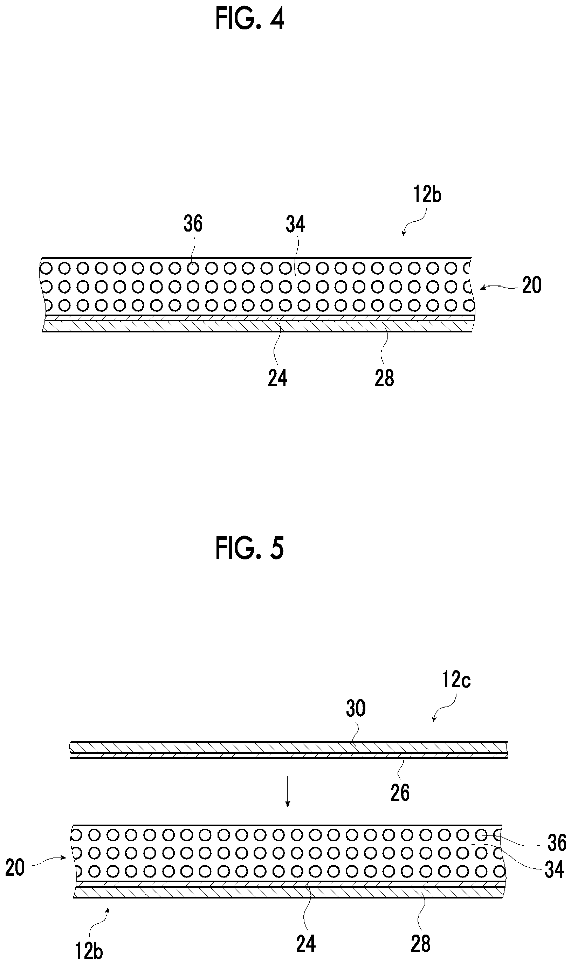

In a case where the sheet-like member 12a is provided and the coating material is provided, the coating material is cast (applied) onto the sheet-like member 12a, and the organic solvent is evaporated and dried. Accordingly, as shown in Fig. 4, a laminate 12b in which the first electrode 24 is provided on the first protective layer 28 and the piezoelectric layer 20 is formed on the first electrode 24 is produced. The first electrode 24 indicates an electrode on the substrate side in a case where the piezoelectric layer 20 is applied, and does not indicate the vertical positional relationship in the laminate.

A casting method of the coating material is not particularly limited, and all known coating methods (coating devices) such as a slide coater or a doctor knife are able to be used.

Alternatively, in a case where the viscoelastic material is a material that is able to be heated and melted like cyanoethylated PVA, a melted material may be produced by heating and melting the viscoelastic material and adding and dispersing the piezoelectric particles 36 therein, extruded into a sheet shape on the sheet-like member 12a shown in Fig. 3 by extrusion molding or the like, and cooled, thereby producing the laminate 12b in which the first electrode 24 is provided on the first protective layer 28 and the piezoelectric layer 20 is formed on the first electrode 24 as shown in Fig. 4.

As described above, in the piezoelectric film 12, in addition to the viscoelastic material such as cyanoethylated PVA, a polymer piezoelectric material such as PVDF may be added to the matrix 34.

In a case where the polymer piezoelectric material is added to the matrix 34, the polymer piezoelectric material added to the coating material may be dissolved. Alternatively, the polymer piezoelectric material to be added may be added to the heated and melted viscoelastic material and may be heated and melted.

After the laminate 12b in which the first electrode 24 is provided on the first protective layer 28 and the piezoelectric layer 20 is formed on the first electrode 24 is produced, the piezoelectric layer 20 is subjected to polarization processing (poling).

A polarization processing method of the piezoelectric layer 20 is not limited, and a known method is able to be used. For example, electric field poling in which a direct current electric field is directly applied to an object subjected to the polarization processing is shown as an example. In a case of performing electric field poling, the first electrode 24 may be formed before the polarization processing, and the electric field poling processing may be performed using the first electrode 24 and the second electrode 26.

Further, in a case of manufacturing the piezoelectric film 12 of the present invention, it is preferable that the polarization processing performs polarization in the thickness direction, not in the plane direction of the piezoelectric layer 20.

Prior to this polarization processing, a calendar processing may be performed in which the surface of the piezoelectric layer 20 is smoothed by using a heating roller or the like. By applying this calendar processing, the thermal compression bonding process described later can be smoothly performed.

In such a manner, while the piezoelectric layer 20 of the laminate 12b is subjected to the polarization processing, as shown in Fig. 5, a sheet-like member 12c is provided in which the second electrode 26 is formed on the second protective layer 30. The sheet-like member 12c may be produced by forming a copper thin film or the like as the second electrode 26 on the surface of the second protective layer 30 using vacuum vapor deposition, sputtering, plating, or the like.

Next, as shown in Fig. 5, the sheet-like member 12c is laminated on the laminate 12b in which the piezoelectric layer 20 is subjected to the polarization processing while the second electrode 26 faces the piezoelectric layer 20.

Furthermore, a laminate of the laminate 12b and the sheet-like member 12c is interposed between the second protective layer 30 and the first protective layer 28, and is subjected to the thermal compression bonding using a heating press device, a heating roller pair, or the like, thereby producing the piezoelectric film 12.

The laminated piezoelectric element 10 of the present invention is obtained by laminating a plurality of layers by folding back the piezoelectric film 12. As a preferred embodiment, the laminated piezoelectric element 10 shown in Fig. 1 has a configuration in which the piezoelectric film 12, which is folded back and laminated, adjacent in the lamination direction is cemented with the cementing layer 14 (cementing agent).

In the present invention, various known cementing layers 14 can be used as long as the adjacent piezoelectric films 12 can be cemented.

Accordingly, the cementing layer 14 may be a layer consisting of an adhesive, which has fluidity during cementing and thereafter is a solid, a layer consisting of a pressure sensitive adhesive which is a gel-like (rubber-like) flexible solid during cementing and does not change in the gel-like state thereafter, or a layer consisting of a material having characteristics of both an adhesive and a pressure sensitive adhesive.

Here, for example, the laminated piezoelectric element 10 of the present invention vibrates a vibration plate 50 as described later and generates a sound by stretching and contracting the plurality of laminated piezoelectric films 12. Accordingly, in the laminated piezoelectric element 10 of the present invention, it is preferable that the stretching and contracting of each piezoelectric film 12 is directly transmitted. In a case where a substance having a viscosity that attenuates vibration is present between the piezoelectric films 12, the efficiency of transmitting the stretching and contracting energy of the piezoelectric film 12 is lowered, and the driving efficiency of the laminated piezoelectric element 10 is also decreased.

In consideration of this point, the cementing layer 14 is preferably an adhesive layer consisting of an adhesive with which a solid and hard cementing layer 14 is obtained, rather than a pressure sensitive adhesive layer consisting of a pressure sensitive adhesive. As a more preferable cementing layer 14, specifically, a cementing layer consisting of a thermoplastic type adhesive such as a polyester-based adhesive or a styrene-butadiene rubber (SBR)-based adhesive is suitably exemplified.

Adhesion, unlike pressure sensitive adhesion, is useful in a case where a high adhesion temperature is required. Furthermore, the thermoplastic type adhesive has "relatively low temperature, short time, and strong adhesion" and is suitable.

The laminated piezoelectric element 10 of the present invention is made by folding back and laminating the piezoelectric film 12. Therefore, in the piezoelectric film 12 of the present invention, in the adjacent piezoelectric film 12, the first electrode 24 and the first protective layer 28 face each other, and the second electrode 26 and the second protective layer 30 face each other.

Therefore, in the adjacent piezoelectric film 12, one or more through-holes are provided in the facing first protective layer 28, and one or more through-holes are provided in the facing second protective layer 30. Then, the adjacent piezoelectric film 12 may be cemented by the conductive cementing layer 14 to fill the through-holes. Alternatively, the through-holes formed in the protective layer may be filled with a conductive material such as silver paste, and then the adjacent piezoelectric film 12 may be cemented by the conductive cementing layer 14.

With such a configuration, even in a case where the electrode layer is broken at the folded-back portion of the piezoelectric film and the wiring line is broken, the driving power can be appropriately supplied to the piezoelectric film 12 of each layer.

The cementing layer 14 having conductivity is not limited, and known ones can be used.

Accordingly, the cementing layer 14 having conductivity may be configured such that the pressure sensitive adhesive, the adhesive, or the like constituting the cementing layer 14 has conductivity. Alternatively, the cementing layer 14 may be made conductive by dispersing metal particles, a conductive filler, metal fibers, or the like in the pressure sensitive adhesive, the adhesive, or the like having no conductivity. Further, a silver paste that cures by drying, such as Dotite manufactured by Fujikura Kasei Co., Ltd., can also be used.

Further, the through-hole may be formed by a known method, for example, by laser processing, or by removing the protective layer by solvent etching or mechanical polishing.

In the laminated piezoelectric element 10 of the present invention, the thickness of the cementing layer 14 is not limited, and a thickness capable of exhibiting sufficient cementing force (adhesive force or pressure sensitive adhesive force) may be appropriately set depending on the forming material of the cementing layer 14.

Here, in the laminated piezoelectric element 10 of the present invention, the thinner the cementing layer 14, the higher the transmission effect of the stretching and contracting energy (vibration energy) of the piezoelectric layer 20, and the higher the energy efficiency. In addition, in a case where the cementing layer 14 is thick and has high rigidity, there is a possibility that the stretching and contracting of the piezoelectric film 12 may be constrained. Further, as described above, in the laminated piezoelectric element 10 of the present invention, the electrode layers having the same polarity face each other in the adjacent piezoelectric film 12. Therefore, there is no possibility that they will short-circuit each other. Therefore, the laminated piezoelectric element 10 of the present invention can make the cementing layer 14 thin.

In consideration of this point, it is preferable that the cementing layer 14 is thinner than the piezoelectric layer 20. That is, in the laminated piezoelectric element 10 of the present invention, it is preferable that the cementing layer 14 is hard and thin.

Specifically, the thickness of the cementing layer 14 is preferably equal to or greater than 0.1 µm and equal to or less than 50 µm, more preferably equal to or greater than 0.1 µm and equal to or less than 30 µm, and even more preferably equal to or greater than 0.1 µm and equal to or less than 10 µm in terms of thickness after cementing.

In the laminated piezoelectric element 10 of the present invention, in a case where the spring constant of the cementing layer 14 is high, there is a possibility that the stretching and contracting of the piezoelectric film 12 may be constrained. Accordingly, it is preferable that the spring constant of the cementing layer 14 is equal to or less than the spring constant of the piezoelectric film 12. The spring constant is "thickness × Young's modulus".

Specifically, the product of the thickness of the cementing layer 14 and the storage elastic modulus (E') at a frequency of 1 Hz in accordance with the dynamic viscoelasticity measurement is preferably 2.0 × 10⁶ N/m or less at 0°C and 1.0 × 10⁶ N/m or less at 50°C.

It is preferable that the internal loss of the cementing layer at a frequency of 1 Hz in accordance with the dynamic viscoelasticity measurement is 1.0 or less at 25°C in the case of the cementing layer 14 consisting of a pressure sensitive adhesive, and is 0.1 or less at 25°C in the case of the cementing layer 14 consisting of an adhesive.

In the laminated piezoelectric element of the present invention, the cementing layer 14 is provided as a preferred embodiment and is not an essential component.

Accordingly, the laminated piezoelectric element of the present invention does not have the cementing layer 14, and the laminated piezoelectric element may be configured such that the piezoelectric films 12 constituting the laminated piezoelectric element are laminated by using known crimping unit, fastening unit, fixing unit, and the like and are in close contact with each other. For example, in a case where the piezoelectric film 12 is rectangular, the laminated piezoelectric element may be configured such that the four corners are fastened with members such as bolts and nuts, or the laminated piezoelectric element may be configured such that the four corners and the central portion are fastened with members such as bolts and nuts. Alternatively, the laminated piezoelectric element may be configured such that the laminated piezoelectric film 12 is fixed by cementing a pressure sensitive adhesive tape to the peripheral portion (end surface) after the piezoelectric film 12 is laminated.

However, in such a case, in a case where the driving voltage is applied from the power source 16, the individual piezoelectric films 12 stretch and contract independently. In some cases, by bending each layer of each piezoelectric film 12 in the opposite direction, it is possible to form an air gap. In such a manner, in a case where the individual piezoelectric films 12 stretch and contract independently, the driving efficiency of the laminated piezoelectric element decreases, and the stretch and contraction of the laminated piezoelectric element as a whole decrease. As a result, the vibration plate and the like that come into contact with each other may not be vibrated sufficiently. In particular, in a case where each layer of each piezoelectric film 12 bends in the opposite direction to form the air gap, the driving efficiency of the laminated piezoelectric element is greatly reduced.

In consideration of this point, it is preferable that the laminated piezoelectric element of the present invention has the cementing layer 14 for cementing adjacent piezoelectric films 12 to each other, as in the laminated piezoelectric element 10 of the example shown in the drawing.

As shown in Fig. 1, the power source 16 for applying a driving voltage for stretching and contracting the piezoelectric film 12 is connected to the first electrode 24 and the second electrode 26 of the piezoelectric film 12.

The power source 16 is not limited and may be a direct-current power source or an alternating-current power source. In addition, as for the driving voltage, a driving voltage capable of appropriately driving each of the piezoelectric films 12 may be appropriately set in accordance with the thickness, forming material, and the like of the piezoelectric film 12 of the piezoelectric layer 20.

The method of leading out the electrode from the first electrode 24 and the second electrode 26 is not limited, and various known methods can be used.

For example, examples thereof include a method of leading out the electrode to the outside by connecting a conductor such as a copper foil to the first electrode 24 and the second electrode 26, a method of leading out the electrodes to the outside by forming the through-holes in the first protective layer 28 and the second protective layer 30 with a laser or the like and filling the through-holes with a conductive material, and the like.

Examples of the suitable method of leading out the electrode include the method described in JP-A-2014-209724, the method described in JP-A-2016-015354, and the like.

Further, a protruding portion where the piezoelectric film 12 protrudes from the laminated piezoelectric element 10 may be provided, and the first electrode 24 and the second electrode 26 of the protruding portion may be connected to an external power source. This point will be described in detail later.

As shown in Fig. 1, the laminated piezoelectric element 10 of the present invention has a structure in which a plurality of layers of the piezoelectric film 12 are laminated by folding back the piezoelectric film 12.

Here, the laminated piezoelectric element 10 of the present invention has a part in which the thickness of the folded-back portion is greater than the thickness of the central portion in the two layers of the piezoelectric film 12 that are folded back and laminated, that is, the two layers of the piezoelectric film 12 which are folded back and laminated and in which the layers are adjacent in the lamination direction.

Specifically, in the adjacent piezoelectric film 12 folded back and laminated, in a case where a thickness of the central portion in the folding-back direction is a center thickness, a length from an end part of a folded-back portion to the central portion in the folding-back direction is L, and a region of 1/3 of the length L from the end part of the folded-back portion to the central portion in the folding-back direction is set as the folded-back portion, the folded-back portion has a part of which a thickness is greater than the center thickness.

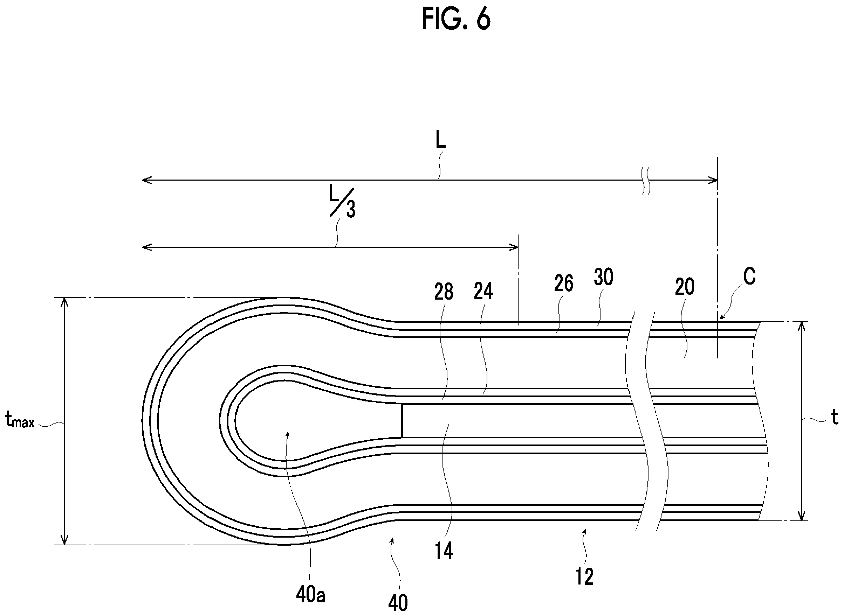

More specifically, as conceptually shown in Fig. 6, in the cross section of the laminated piezoelectric element 10 in the folding-back direction observed with an optical microscope or a scanning electron microscope, the thickness of the central portion C in the folding-back direction, that is, the center thickness is set as a thickness t.

As shown in the example shown in the drawing, in a case where the laminated piezoelectric element 10 has the cementing layer 14 to which the adjacent two layers of the piezoelectric film 12 folded back and laminated are cemented, the thickness t of the central portion C is set as a sum of the thicknesses of the adjacent two layers of the piezoelectric film 12 folded back and laminated and the thickness of the cementing layer 14 interposed therebetween, that is, "the thickness t of the central portion C = the thickness of the piezoelectric film 12 + the thickness of the cementing layer 14 + the thickness of the piezoelectric film 12". In a case where the laminated piezoelectric element 10 does not have the cementing layer 14, the thickness t of the central portion C is set as a sum of the thicknesses of the adjacent two layers of the piezoelectric film 12 folded back and laminated, that is, "the thickness t of the central portion C = the thickness of the piezoelectric film 12 + the thickness of the piezoelectric film 12".

Further, in this cross section, a length from the end part on the distal end side of the folded-back portion in the folding-back direction to the central portion C is set as L.

Further, in this cross section, a region of 1/3 of the length L (region of L/3) is set as the folded-back portion 40 from the end part on the distal end side of the folded-back portion in the folding-back direction.

The laminated piezoelectric element 10 of the present invention has a part in which the thicknesses of all the folded-back portions 40 obtained by folding back the piezoelectric film 12 is larger than the thickness t of the central portion C.

In the present invention, the thickness t is a thickness of the piezoelectric film 12 in the lamination direction. Further, the central portion C in the folding-back direction is a central portion of the piezoelectric film 12 in the folding-back direction in a planar shape in a case where the laminated piezoelectric element 10 is viewed in the lamination direction. In other words, the lamination direction is a direction orthogonal to the principal surface (largest surface) of the piezoelectric film 12.

Further, as shown in Fig. 6, the laminated piezoelectric element 10 of the present invention has an air gap 40a between the piezoelectric films 12 forming the folded-back portion 40, that is, between the folded back and adjacent piezoelectric films 12, in the folded-back portion 40.

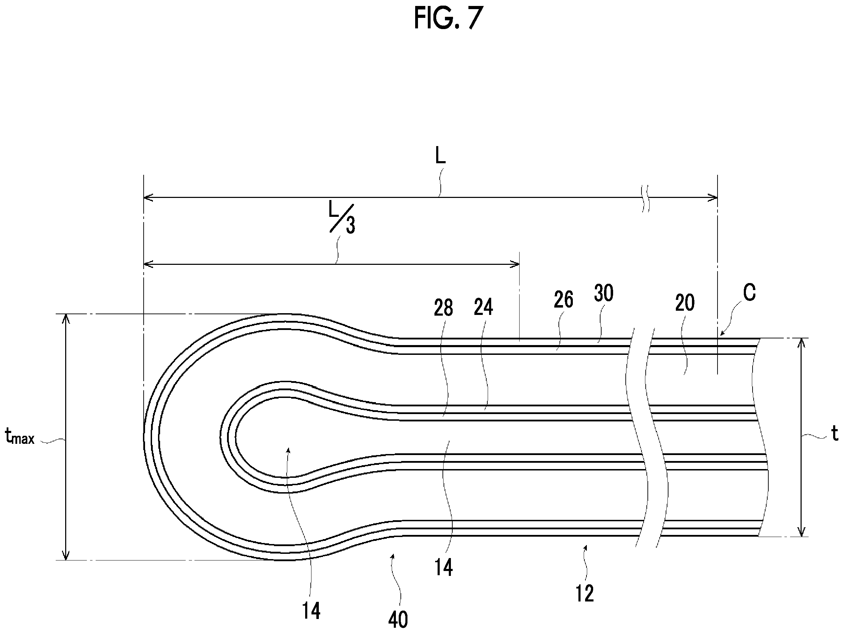

Alternatively, in the laminated piezoelectric element 10 of the present invention, as conceptually shown in Fig. 7, in the folded-back portion 40, a space between the piezoelectric films 12 forming the folded-back portion 40 is filled with the cementing layer 14, that is, the cementing agent after curing.

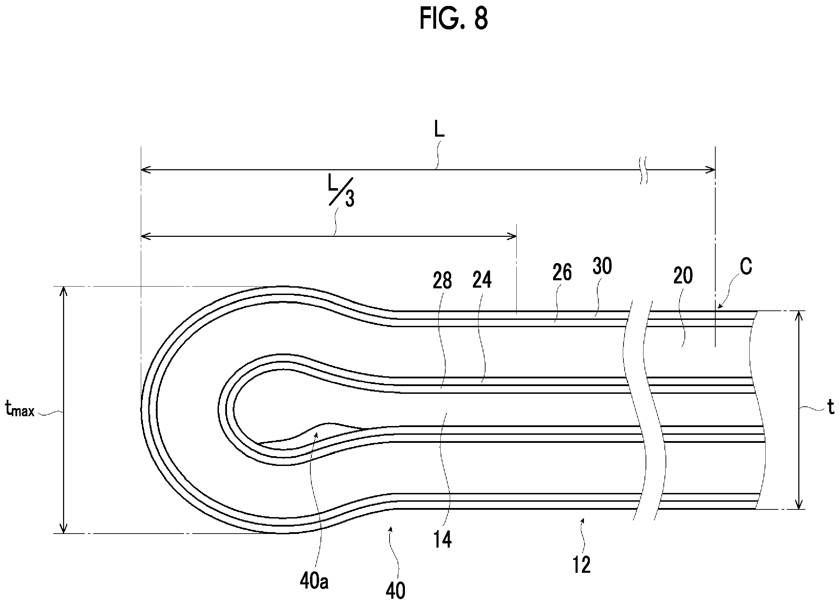

In the laminated piezoelectric element 10 of the present invention, in the configuration having an air gap 40a between the piezoelectric films 12 forming the folded-back portion 40, for example as conceptually shown in Fig. 8, an optional part of the folded-back portion 40 or each of a plurality of portions thereof may be the air gap 40a. Consequently, there is no limitation on a position of the air gap 40a in the folded-back portion 40.

The laminated piezoelectric element 10 of the present invention is formed by returning a sheet-like member in a bellows shape. In such a laminated piezoelectric element 10 of the present invention, in the adjacent two layers of the piezoelectric film 12 which are folded back and laminated, the shape of the folded-back portion, the maximum thickness of the folded-back portion, and the thickness of the central portion C in a direction orthogonal to the folding-back direction are substantially the same throughout the entire region. The direction orthogonal to the folding-back direction is a direction orthogonal to the paper surface in Figs. 1 and 6 to 8.

Accordingly, in the laminated piezoelectric element 10 of the present invention, such an observation may be performed on an optional one cross section in the folding-back direction, and all the folded-back portions may satisfy the above conditions in the optional one cross section.

In addition, the cross section of the laminated piezoelectric element 10 with a microscope may be observed by embedding the sample to be observed in a transparent resin such as an epoxy resin and performing cross-section processing on the laminated piezoelectric element 10 in the folding-back direction using a microtome and ion milling.

In a case of observing with a scanning electron microscope, an osmium coat may be provided on the cut surface, as necessary.

The laminated piezoelectric element 10 of the present invention has such a configuration. With such a configuration, the desired piezoelectric performance can be obtained by preventing peeling off of the first electrode 24 and the first protective layer 28, and the second electrode 26 and the second protective layer 30 are piezoelectric materials in the folded-back portion 40 from the piezoelectric layer 20 and by preventing breaking of the first electrode 24 and the second electrode.

As described in JP2015-70110A, by laminating a plurality of piezoelectric films to form a laminate, the rigidity of the piezoelectric film as a whole is increased, the piezoelectric effect can be improved, and excellent piezoelectric characteristics can be exhibited.

In such a laminate, as described in JP2015-70110A, by folding back and laminating one piezoelectric film, the configuration is simplified and the production is easy. In addition, since one piezoelectric film is folded back, it is not necessary to supply driving power to each piezoelectric film as in the case of laminating a plurality of piezoelectric films, and connection with an external power source is also easy.

However, in the configuration in which the piezoelectric film is folded back to form a plurality of layers and laminated as described in JP2015-70110A, the outside of the piezoelectric film is in an extended state and the inside is in a contracted state in the folded-back portion.

Therefore, stress is applied to the electrode layer at the folded-back portion, and the electrode layer may be broken at the outside of the folded-back portion. Further, inside of the folded-back portion, the electrode layer may be peeled off from the piezoelectric layer due to the contracted stress and may be lifted.

In a case where the electrode layer breaks, electric power is concentrated on that part, causing inconveniences such as heat generation. Further, in a case where the electrode layer is peeled off, the piezoelectric layer can not be driven, and the relative permittivity of the peeled portion changes. Therefore, the desired piezoelectric characteristics cannot be obtained.

On the other hand, in the laminated piezoelectric element 10 of the present invention, the piezoelectric film 12 which is folded back and laminated, that is, the piezoelectric film 12 which is made adjacent by being folded back, has a part where the thickness of the folded-back portion 40 is larger than the thickness t of the central portion C, and the folded-back portion 40 has an air gap, or is filled with the cementing layer 14.

Therefore, in the laminated piezoelectric element 10 of the present invention, the folding back of the piezoelectric film 12 at the folded-back portion 40 is gentle. That is, the laminated piezoelectric element 10 of the present invention can increase a curvature of the folded piezoelectric film 12 in the folded-back portion 40.

Thereby, the laminated piezoelectric element 10 of the present invention can reduce a stress applied to the electrode and the protective layer in the folded-back portion 40. Therefore, in the laminated piezoelectric element 10 of the present invention, the first electrode 24 and the first protective layer 28, and the second electrode 26 and the second protective layer 30 are able to prevent peeling off from the piezoelectric layer 20 in the folded-back portion 40 and breaking of the first electrode 24 and the second electrode 26. As a result, the laminated piezoelectric element 10 of the present invention is able to stably exhibit the desired piezoelectric performance.

In the laminated piezoelectric element 10 of the present invention, there is no limitation on the thickness of the folded-back portion 40 with respect to the thickness t of the central portion C. That is, in the laminated piezoelectric element 10 of the present invention, the folded-back portion 40 may have a part of which a thickness is greater than the thickness t of the central portion C.

In the present invention, basically, the larger the difference between the thickness of the folded-back portion 40 and the thickness t of the central portion C, the more preferable prevention of peeling off of the piezoelectric layer 20 from the first electrode 24 and the second electrode 26.

In consideration of this point, in the laminated piezoelectric element 10 of the present invention, the maximum thickness tₘₐₓ of the folded-back portion 40 is preferably 1.1 times or more, more preferably 1.5 times or more, and even more preferably twice or more the thickness t of the central portion C.

In a case where the thickness of the folded-back portion 40 is excessively thick, there may be disadvantages that the laminated piezoelectric element 10 is unnecessarily thick and in the laminated piezoelectric element 10, the difference in thickness between the position corresponding to the folded-back portion 40 and the central portion C is large.

In consideration of this point, the maximum thickness tₘₐₓ of the folded-back portion 40 is preferably 10 times or less the thickness t of the central portion C.

The thickness t of the central portion C may be measured by observing in the same manner as the thickness of the folded-back portion 40 described above.

Such a laminated piezoelectric element 10 of the present invention can be manufactured by various methods.

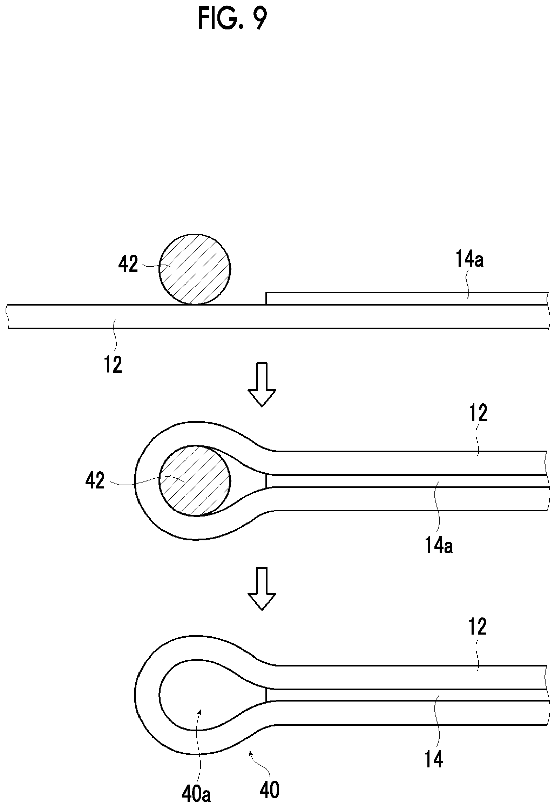

For example, the laminated piezoelectric element 10 having an air gap 40a in the vicinity of the outer end part of the folded-back portion 40 as shown in Fig. 6 may be manufactured as shown in Fig. 9 as an example.

In this method, first, as shown in the upper part, the cementing agent 14a to be the cementing layer 14 is applied to the piezoelectric film 12, and the columnar rod-like body 42 is brought into contact with the piezoelectric film 12.

Next, as shown in the middle part, the piezoelectric film 12 is folded back with the rod-like body 42 as a fulcrum and laminated on the cementing agent 14a.

Then, the cementing agent 14a is cured, the folded piezoelectric film 12 is cemented, and then the rod-like body 42 is pulled out as shown in the lower part.

By repeating this, the laminated piezoelectric element 10 in which the vicinity of the outer end part of the folded-back portion 40 is the air gap 40a can be manufactured.

In this manufacturing method, in a case where the rod-like body 42 is left as it is, the rod-like body 42 inhibits the vibration of the piezoelectric film 12, and the weight is partially increased. As a result, the piezoelectric characteristics of the laminated piezoelectric element are changed, and desired performance cannot be obtained.

Moreover, since the rod-like body 42 inhibits the vibration of the piezoelectric film 12, one or more of the first electrode 24 and the second electrode 26 and the first protective layer 28 and the second protective layer 30 may be damaged.

Accordingly, in this manufacturing method, it is essential to remove the rod-like body 42.

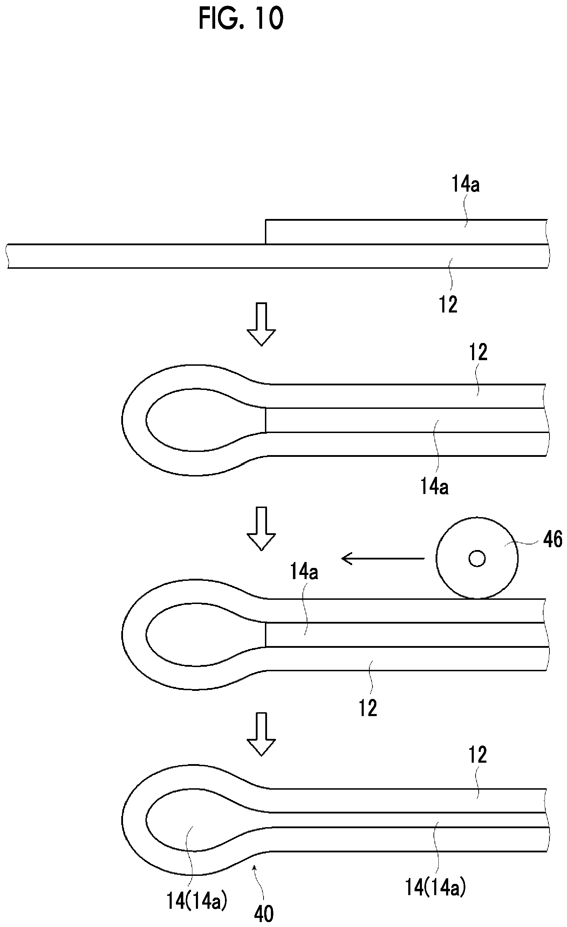

As shown in Fig. 7, the laminated piezoelectric element 10 in which the folded-back portion 40 is filled with the cementing layer 14 may be manufactured as shown in Fig. 10 as an example.

In this method, first, as shown in the upper part, the cementing agent 14a to be the cementing layer 14 is applied to the piezoelectric film 12. At this time, the thickness of the cementing agent 14a is made greater than the thickness of the cementing layer 14 assumed in the laminated piezoelectric element 10.

Next, as shown in the second part from the top, the piezoelectric film 12 is folded back and laminated on the cementing agent 14a.

Next, as shown in the third part from the top, the roller 46 presses the laminated piezoelectric film 12 from the center side toward the end part of the folded-back portion. Thereby, as shown in the lower part, the folded-back portion 40 can be filled with the cementing agent 14a. Thereafter, the cementing agent 14a is cured to form the cementing layer 14.

By repeating this, the laminated piezoelectric element 10 in which the folded-back portion 40 is filled with the cementing layer 14 can be manufactured.

As described above, the laminated piezoelectric element 10 of the present invention has a configuration in which a plurality of layers of the piezoelectric film 12 are laminated by folding back the piezoelectric film 12. The folded back and laminated piezoelectric film 12 has a part, of which the thickness is greater than the central portion, in the folded-back portion 40.

Therefore, in a case where the laminated piezoelectric element 10 of the present invention is folded three or more times and the folded-back portions 40 are laminated, the end part of the laminated piezoelectric element 10 in the folding-back direction may be thicker than the central portion in accordance with the thickness of the folded-back portion 40.

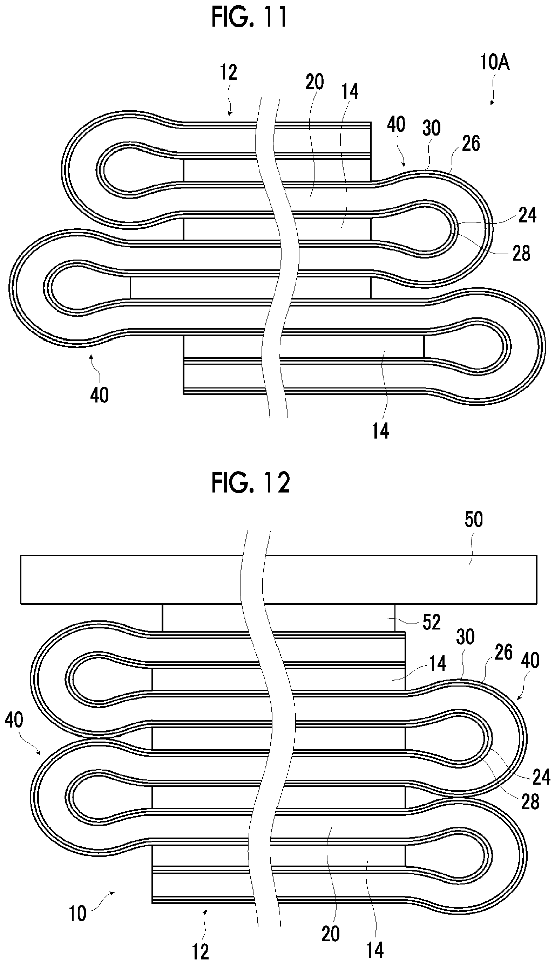

In order to prevent this, in the laminated piezoelectric element of the present invention, in a case where the piezoelectric film 12 is folded back three times or more, as in the laminated piezoelectric element 10A conceptually shown in Fig. 11, it is preferable that the positions of the end parts of the folded-back portions 40 adjacent in the lamination direction of the piezoelectric film 12 are set as positions different from that in the folding-back direction of the piezoelectric film 12. That is, it is preferable that the positions of the end parts of the folded-back portions 40 adjacent in the lamination direction of the piezoelectric film 12 are shifted in the folding-back direction of the piezoelectric film 12.

Thereby, the thickness of the laminated piezoelectric element 10A can be made uniform throughout the entire surface.

In the folded-back portion 40, the amount of deviation of the position of the end part in the folding-back direction is not limited, and the amount of deviation that makes the thickness of the laminated piezoelectric element uniform in the plane direction may be appropriately set. Accordingly, at least in the folded-back portion 40 adjacent in the lamination direction, the position of the maximum thickness tₘₐₓ may be different in the folding-back direction.

As described above, the laminated piezoelectric element of the present invention may be a laminate of a plurality of laminated piezoelectric elements obtained by folding back the piezoelectric film 12 once or more. Similarly, in this case as well, it is preferable to shift the position of the end part in the folding-back direction in the folded-back portion adjacent to the lamination direction.

For example, as conceptually shown in Fig. 12, the laminated piezoelectric element 10 of the present invention is cemented (fixed) to the vibration plate 50 by the cementing layer 52, and is used as an exciter for generating a sound from the vibration plate 50. In other words, the vibration plate 50 and the laminated piezoelectric element 10 are in contact with each other and fixed to each other through the cementing layer 52, and the laminated piezoelectric element 10 functions as an exciter for generating sound from the vibration plate 50.

Consequently, Fig. 12 shows an example of the electroacoustic transducer of the present invention.

As described above, in the laminated piezoelectric element 10 of the present invention, the piezoelectric layer 20 constituting the piezoelectric film 12 which is laminated in a plurality of layers is formed by dispersing the piezoelectric particles 36 in the matrix 34. Further, the first electrode 24 and the second electrode 26 are provided with the piezoelectric layer 20 interposed therebetween in the thickness direction.

In a case where a voltage is applied to the first electrode layer 24 and the second electrode 26 of the piezoelectric film 12 having the piezoelectric layer 20, the piezoelectric particles 36 stretch and contract in the polarization direction according to the applied voltage. As a result, the piezoelectric film 12 (piezoelectric layer 20) contracts in the thickness direction. At the same time, the piezoelectric film 12 stretches and contracts in the plane direction due to the Poisson's ratio.

The degree of stretching and contracting is equal to or greater than about 0.01% and equal to or less than about 0.1%.

As described above, the thickness of the piezoelectric layer 20 is preferably equal to or greater than about 8 µm and equal to or less than about 300 µm. Accordingly, the degree of stretching and contracting in the thickness direction is as extremely small as about 0.3 µm at the maximum.

Contrary to this, the piezoelectric film 12, that is, the piezoelectric layer 20, has a size much larger than the thickness in the plane direction. Accordingly, for example, in a case where the length of the piezoelectric film 12 is 20 cm, the piezoelectric film 12 stretches and contracts by a maximum of about 0.2 mm as a voltage is applied.

As described above, the vibration plate 50 is cemented to the laminated piezoelectric element 10 by the cementing layer 52. Accordingly, the stretching and contracting of the piezoelectric film 12 causes the vibration plate 50 to bend, and as a result, the vibration plate 50 vibrates in the thickness direction.

The vibration plate 50 emits a sound due to the vibration in the thickness direction. That is, the vibration plate 50 vibrates in accordance with the magnitude of the voltage (driving voltage) applied to the piezoelectric film 12, and generates a sound in accordance with the driving voltage applied to the piezoelectric film 12.

Here, it is known that in a case where a general piezoelectric film consisting of a polymer material such as PVDF is stretched in a uniaxial direction after being subjected to polarization processing, the molecular chains are oriented with respect to the stretching direction, and as a result, high piezoelectric characteristics are obtained in the stretching direction. Therefore, a general piezoelectric film has in-plane anisotropy in the piezoelectric characteristics, and has anisotropy in the amount of stretching and contracting in the plane direction in a case where a voltage is applied.

On the other hand, in the laminated piezoelectric element 10 of the present invention, the piezoelectric film 12 consisting of a polymer-based piezoelectric composite material in which piezoelectric particles 36 are dispersed in a matrix 34 is able to obtain large piezoelectric characteristics without stretching processing after polarization processing. Therefore, the piezoelectric film 12 has no in-plane anisotropy in the piezoelectric characteristics, and stretches and contracts isotropically in all directions in the plane direction. That is, in the laminated piezoelectric element 10 of the present invention, the piezoelectric film 12 isotropically and two-dimensionally stretches and contracts. In the laminated piezoelectric element 10 of the present invention in which such piezoelectric films 12 that stretch and contract isotropically and two-dimensionally are laminated, compared to a case where general piezoelectric films made of PVDF or the like that stretch and contract greatly in only one direction are laminated, the vibration plate 50 can be vibrated with a large force, and a louder and more beautiful sound can be generated.

As described above, the laminated piezoelectric element of the present invention is a laminated piezoelectric element in which a plurality of layers are laminated by folding back such a piezoelectric film 12. In the laminated piezoelectric element 10 of the example shown in the drawing, as a preferred embodiment, the adjacent piezoelectric films 12 are further cemented to each other by the cementing layer 14.

Therefore, even though the rigidity of each piezoelectric film 12 is low and the stretching and contracting force thereof is small, the rigidity is increased by laminating the piezoelectric films 12, and the stretching and contracting force as the laminated piezoelectric element 10 is increased. As a result, in the laminated piezoelectric element 10 of the present invention, even in a case where the vibration plate 50 has a certain degree of rigidity, the vibration plate 50 is sufficiently bent with a large force and the vibration plate 50 can be sufficiently vibrated in the thickness direction, whereby the vibration plate 50 can generate a sound.

In addition, the thicker the piezoelectric layer 20, the larger the stretching and contracting force of the piezoelectric film 12, but the larger the driving voltage required for stretching and contracting by the same amount. Here, as described above, in the laminated piezoelectric element 10 of the present invention, a preferable thickness of the piezoelectric layer 20 is about 300 µm at the maximum. Therefore, even in a case where the voltage applied to each piezoelectric film 12 is small, it is possible to sufficiently stretch and contract the piezoelectric films 12.

In the electroacoustic transducer of the present invention using the laminated piezoelectric element of the present invention, the cementing layer 52 that cements the laminated piezoelectric element 10 to the vibration plate 50 is not limited, and various known pressure sensitive adhesive and adhesives can be used.

For example, the same as the above-mentioned cementing layer 14 is exemplified. The preferred cementing layer 52 (cementing agent) is the same as that of the cementing layer 14.

In the electroacoustic transducer of the present invention using the laminated piezoelectric element of the present invention, the vibration plate 50 is not limited, and various articles can be used.

As the vibration plate 50, for example, plate materials such as resin plates and glass plates, advertisement or notification media such as signboards, office devices and furniture such as tables, whiteboards, and projection screens, display devices such as organic electroluminescence (organic light emitting diode (OLED)) displays and liquid crystal displays, members for vehicles including automobiles such as consoles, A-pillars, roofs, and bumpers, and building materials such as walls of houses are exemplified.

In the electroacoustic transducer of the present invention, the vibration plate 50 to which the laminated piezoelectric element 10 of the present invention is cemented preferably has flexibility, and more preferably rollable.

As the flexible vibration plate 50, a flexible panel-shaped display device such as a flexible display panel is particularly suitably exemplified. Further, it is more preferable that the display device is also rollable.

Here, the electroacoustic transducer of the present invention responds to the curvature of roll of the vibration plate 50 such that the laminated piezoelectric element 10 does not peel off from the vibration plate 50 in a case where the vibration plate 50 is rolled. Therefore, it is preferable that the laminated piezoelectric element 10 also bends together with the vibration plate 50. The piezoelectric film 12 has suitable flexibility. Therefore, the laminated piezoelectric element 10 of the present invention also basically exhibits favorable flexibility.

In such a case, the curvature of roll of the vibration plate 50 is basically a specific curvature, but the curvature of roll of the vibration plate 50 may be variable.

In a configuration in which the laminated piezoelectric element to be described later protrudes from the end part in the longitudinal direction and has a protruding portion 58 of which the length in the longitudinal direction is 10% or more of the longitudinal direction of the laminated piezoelectric element, particularly in the electroacoustic transducer of the present invention using such a rollable vibration plate 50, the effect is exhibited and the sound pressure can be improved.

In the electroacoustic transducer of the present invention, in a case where the display device is a vibration plate 50, it is preferable that the laminated piezoelectric element 10 is cemented to the rear side of the display device, that is, the non-image display surface side of the display device.

In such a case, the size of the cementing layer 52 in the plane direction is preferably the same size as or smaller than the size of the planar shape of the laminated piezoelectric element 10.

In the electroacoustic transducer of the present invention, in a case where the display device is used as the vibration plate 50, the display device itself such as a flexible display panel may be the vibration plate 50, or a plate-shaped display device provided on the display device or a plate-shaped member that engages with the member or the display device may be the vibration plate 50.

Further, in a case where the electroacoustic transducer of the present invention is used as a display device, the electroacoustic transducer of the present invention may be incorporated in the display device. Alternatively, the vibration plate 50 of the electroacoustic transducer of the present invention may vibrate the plate-shaped member provided in the display device. Alternatively, the electroacoustic transducer of the present invention may be incorporated in a casing or the like together with the display device.

In the electroacoustic transducer of the present invention, in a case where the vibration plate 50 can be rolled, it is preferable that the laminated piezoelectric element 10 is cemented to the vibration plate 50 with the longitudinal direction thereof made to coincide with the rolling direction of the vibration plate 50. The longitudinal direction and a lateral direction of the laminated piezoelectric element will be described in detail later.

In a case where the rolling direction of the vibration plate 50 and the longitudinal direction of the laminated piezoelectric element 10 coincide with each other. Therefore, compared to the case where the rolling direction of the vibration plate 50 and the lateral direction of the laminated piezoelectric element 10 coincide with each other, the vibration plate 50 and the laminated piezoelectric element 10 is rollable with less force.

In the electroacoustic transducer of the present invention, in a case where the vibration plate 50 can be rolled, a drive current is applied to the laminated piezoelectric element 10 in a state where the vibration plate 50 is not rolled, and the vibration plate 50 is rolled. At that time, it is preferable that the current is not applied to the laminated piezoelectric element 10.

Further, in the electroacoustic transducer of the present invention, in a case where the vibration plate 50 is electrically driven like a display device, the drive current is applied to the laminated piezoelectric element 10 and/or the vibration plate 50 without rolling the vibration plate 50, and the vibration plate 50 is rolled. At that time, it is preferable not to apply the current to the laminated piezoelectric element 10 and/or the vibration plate 50.

As a method of switching between current application and non-current application, various known methods can be used.

As described above, the electroacoustic transducer of the present invention is formed by cementing (fixing) the laminated piezoelectric element 10 to the vibration plate 50 by using the cementing layer 52.

In such an electroacoustic transducer of the present invention, the end part (end side) of the vibration plate 50 may be fixed to a wall or the like, and/or the end part may be fixed by a fixing unit such as a beam.

Further, in the electroacoustic transducer of the present invention, the shape of the vibration plate 50 is not limited, but in most cases, the shape may be a quadrangle. For example, as described above, in the electroacoustic transducer of the present invention, a display device such as an organic electroluminescence display can be suitably used as the vibration plate 50. In a case where the display device is a vibration plate, the vibration plate 50 is usually rectangular.

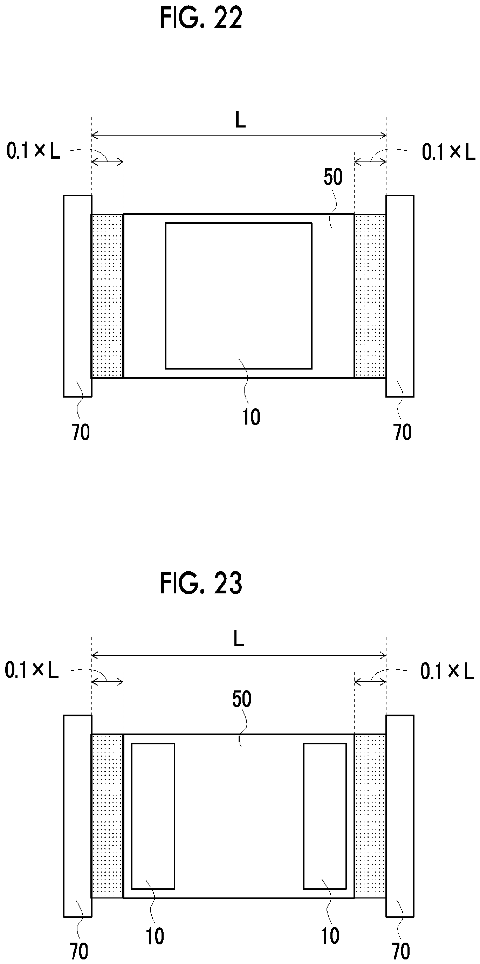

In a case where the vibration plate 50 is a quadrangle such as a rectangle or a square, in order to stably fix the vibration plate 50, in most cases, the two facing sides are fixed by the fixing unit 70 as conceptually shown in Fig. 22, and the vibration plate 50 is supported.

Here, as conceptually shown in Fig. 22, the distance between the two fixing units 70 for fixing the two facing sides of the quadrangular vibration plate 50, that is, the distance between the fixed ends of the vibration plate 50 is L.

In the electroacoustic transducer of the present invention, in a case where the two facing sides of the quadrangular vibration plate 50 are fixed, it is preferable that the laminated piezoelectric element 10 is cemented to the vibration plate 50 in a state where the two facing sides are separated by 0.1 × L or greater from the inner end parts of the vibration plate of the fixing unit 70, that is, from the fixed ends of the vibration plate 50.

That is, in a case where fixing the two facing sides of the quadrangular vibration plate 50, it is preferable to have a slight air gap between the fixed end of the vibration plate 50 and the laminated piezoelectric element 10.

By adopting such a configuration, fixing of the vibration plate 50 suppresses the stretch and contraction of the laminated piezoelectric element 10 described above, and more suitably vibrates the vibration plate 50. As a result, it is possible to output a sound having a higher sound pressure.

In such a case, as shown in Fig. 12, in a case where the end part of the laminated piezoelectric element 10 protrudes outward of the cementing layer 52 in the plane direction, the end part of the cementing layer 52 is regarded as the end part of the laminated piezoelectric element 10. That is, in such a case, the laminated piezoelectric element is cemented such that the end part of the cementing layer 52 is separated from the fixed end of the vibration plate 50 by 0.1 × L or greater.

On the contrary, in a case where the end part of the laminated piezoelectric element 10 is located inside the cementing layer 52 in the plane direction, the laminated piezoelectric element may be cemented such that the end part of the laminated piezoelectric element 10 is separated from the fixed end of the vibration plate 50 by 0.1 × L or greater.

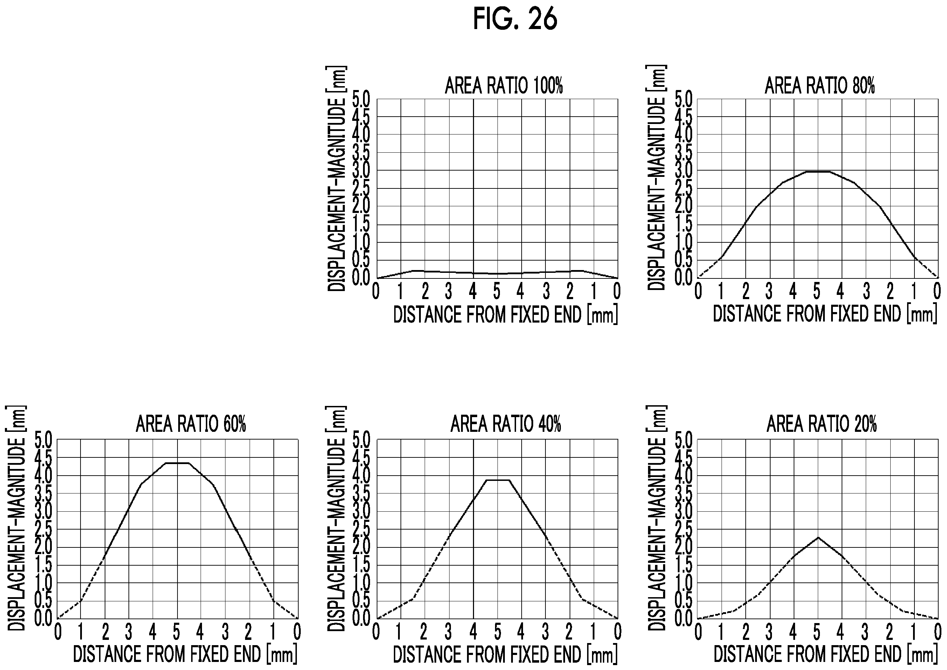

Fig. 26 shows the simulation results of the relationship between the distance from the fixed end of the vibration plate to the laminated piezoelectric element and the displacement of the vibration plate in a case where laminated piezoelectric elements of various sizes are cemented to the quadrangular vibration plate.

The end parts (end sides) of the two facing sides of the vibration plate were fixed using a stainless steel square plate having a size of 10 × 10 mm and a thickness of 0.3 mm.

In the laminated piezoelectric element, four layers of the square piezoelectric film 12 shown in Fig. 2 were laminated, and each layer was cemented by a cementing layer.

The laminated piezoelectric element was provided with a cementing layer on the entire surface, and the laminated piezoelectric element was cemented to the center of the vibration plate in a state where the directions of the respective sides were matched. Accordingly, in a case where the size of the laminated piezoelectric element is different, the distance from the fixed end of the vibration plate to the laminated piezoelectric element is different.

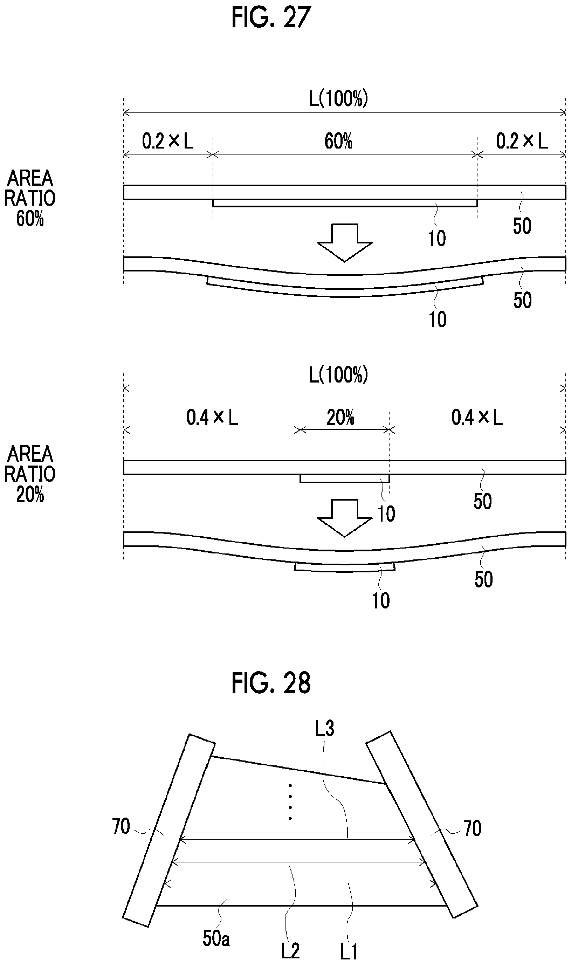

As conceptually shown in Fig. 27, an area ratio in Fig. 26 is a one-dimensional area ratio in a case where the distance L between the fixed ends of the vibration plate is 100%. That is, the area ratio of 100% is a case where the laminated piezoelectric element is cemented to the entire surface from the fixed end to the fixed end of the vibration plate. Further, the area ratio of 60% is a case where the laminated piezoelectric element is cemented to the vibration plate at a distance of 0.2 × L mm from the fixed end of the vibration plate, as shown in the upper part of Fig. 27. Further, the area ratio of 20% is a case where the laminated piezoelectric element is cemented to the vibration plate at a distance of 0.4 × L mm from the fixed end of the vibration plate, as shown in the lower part of Fig. 27.

In Fig. 26, the broken line is a region where the laminated piezoelectric element is not present in the vibration plate, and the solid line is a region where the laminated piezoelectric element is cemented to the vibration plate.

As shown in Fig. 26, in a case where the area ratio is 100%, that is, in a case where the laminated piezoelectric element is cemented from the fixed end to the fixed end of the vibration plate, the displacement, that is, the vibration of the vibration plate is small.

On the other hand, the vibration plate can be vibrated sufficiently large by cementing the laminated piezoelectric element to the vibration plate at an area ratio of 80%, that is, a distance of 0.1 × L mm from the fixed end of the vibration plate. Consequently, a high sound pressure can be obtained.

Further, in this example, in a case where the area ratio is 60%, that is, as shown in the upper part of Fig. 27, in a case where the laminated piezoelectric element is cemented to the vibration plate at a distance of 0.2 × L mm from the fixed end of the vibration plate, the vibration plate 50 is displaced by a larger amount. Consequently, a higher sound pressure can be obtained.

As described above, in the electroacoustic transducer of the present invention, in a case where fixing the two facing sides of the quadrangular vibration plate, by cementing the laminated piezoelectric element to the vibration plate at a distance of 0.1 × L mm or greater from the fixed end of the vibration plate, it is possible to more suitably vibrate the vibration plate and output a sound having a higher sound pressure.

Further, in this example, in a case where the area ratio is 40%, that is, in a case where the laminated piezoelectric element is cemented to the vibration plate at a distance of 0.3 × L mm from the fixed end of the vibration plate, the vibration plate 50 is displaced by a sufficiently large amount. Consequently, a sufficiently high sound pressure can be obtained.

Further, in this example, in a case where the area ratio is 20%, that is, in a case where the laminated piezoelectric element is cemented to the vibration plate at a distance of 0.4 × L mm from the fixed end of the vibration plate as shown in the lower part of Fig. 27, the vibration plate 50 is displaced by a sufficiently large amount as compared with a case where the area ratio is 100%. Consequently, a sufficiently high sound pressure can be obtained.

Therefore, in the electroacoustic transducer of the present invention, in a case where fixing the two facing sides of the quadrangular vibration plate, by cementing the laminated piezoelectric element to the vibration plate at a distance of 0.4 × L mm or less from the fixed end of the vibration plate, it is possible to suitably vibrate the vibration plate and output a sound having a high sound pressure.

In the electroacoustic transducer of the present invention, there is no limitation on the fixing unit 70 for fixing the side of the vibration plate 50, and various known fixing units for fixing the side (end side) of the plate-like member (sheet-like member, film) are available. Examples of the fixing unit include a beam that is able to support the sides of a plate-like member (including a cantilever), a fixing member that is used to support the sides of a projection screen, a fixing mechanism for a sheet-like member that is provided at a sheet drawer port of a container which draws out and contains the rolled sheet-like member such as a cartridge to be freely rolled, and the like.

Further, the fixing of the vibration plate 50 is not limited to the use of the fixing unit 70. For example, the vibration plate 50 may be fixed by directly cementing the end part (end surface) of the vibration plate 50 to a wall, a plate-like member serving as a support, or the like through a cementing agent or the like. In such a case, the end part of the vibration plate is the fixed end of the vibration plate 50.

The electroacoustic transducer of the present invention is not limited to having one laminated piezoelectric element 10.

For example, in an electroacoustic transducer, in a case where audio is reproduced in stereo, that is, in two channels, as conceptually shown in Fig. 23, the distance between the fixed ends is separated in the L direction, and the two laminated piezoelectric elements 10 may be cemented to the vibration plate 50. Even in such a case, it is preferable that the laminated piezoelectric element 10 is cemented to the vibration plate 50 at a distance of 0.1 × L or greater from the fixed end of the vibration plate 50, where L is the distance between the two fixing units 70, that is, the distance between the fixed ends of the vibration plate 50.

Further, in the electroacoustic transducer of the present invention, all four sides of the rectangular (square) vibration plate 50 may be fixed, for example, like a picture frame.

In this case as well, similarly, it is preferable that the fixed position of the laminated piezoelectric element 10 is determined to correspond to each of the fixing unit 70a for fixing one facing two sides and the fixing unit 70b for fixing the other two facing sides.

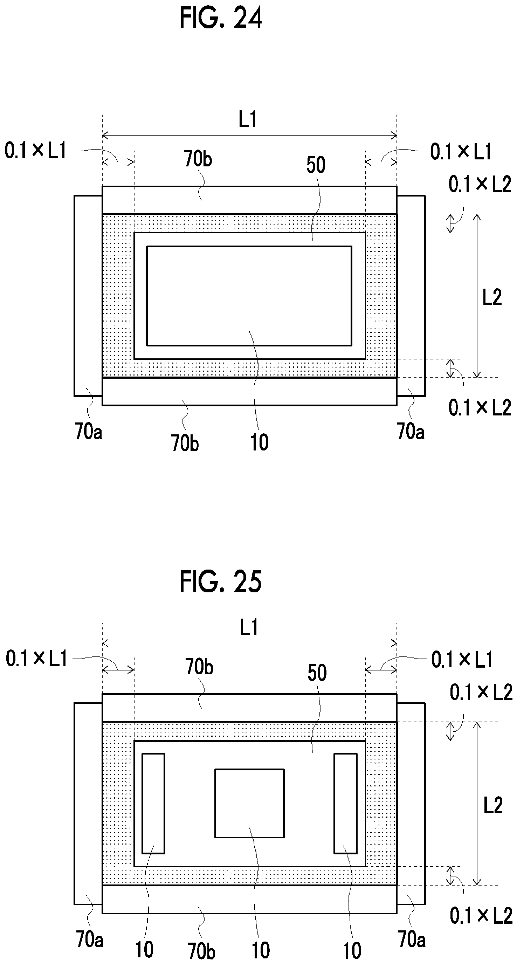

In such a case, as conceptually shown in Fig. 24, it is assumed that the distance between the two fixing units 70a for fixing one of the facing sides of the vibration plate 50, that is, the distance between the fixed ends of the vibration plate 50 on the facing sides is L1. Further, it is assumed that the distance between the two fixing units 70b for fixing the other facing sides of the vibration plate 50, that is, the distance between the fixed ends of the vibration plate 50 on the facing sides is L2.

Then, as shown in Fig. 24, in the vibration plate 50, it is preferable that the laminated piezoelectric element 50 is cemented at a distance of 0.1 × L1 or greater from the end part of the fixing unit 70a, that is, the fixed end by the fixing unit 70a, and at a distance of 0.1 × L2 or greater from the end part of the fixing unit 70b, that is, from the fixed end by the fixing unit 70b.

In the electroacoustic transducer of the present invention, even in a case where all four sides of the rectangular vibration plate 50 are fixed, there is no limitation on having only one laminated piezoelectric element 10.

For example, in an electroacoustic transducer, audio may be reproduced in stereo and reproduced in 2.5 channels such as providing a center speaker. In such a case, as conceptually shown in Fig. 25, two laminated piezoelectric elements 10 for stereo reproduction may be provided near the end parts in the direction of the distance L1 between the long fixed ends, and the laminated piezoelectric element 10 for the center speaker is provided in the center thereof.

Even in such a case, regarding the laminated piezoelectric element 10, it is preferable that three laminated piezoelectric elements 50 are cemented at positions separated by a distance of 0.1 × L1 or greater from the fixed end by the fixing unit 70a and a distance of 0.1 × L2 or greater from the fixed end by the fixing unit 70b, in accordance with the distance L1 between the fixed ends by the fixing unit 70a for fixing one opposite side and the distance L2 between the fixed ends by the fixing unit 70b for fixing the other opposite side.

As described above, in the electroacoustic transducer of the present invention, it is preferable that the laminated piezoelectric element 10 is cemented to the vibration plate at a distance of 0.1 × L or greater from the end part of the fixing unit for fixing the facing sides of the quadrangular vibration plate 50, that is, from the fixed ends of the facing sides of the quadrangular vibration plate 50.

Here, it is preferable that the distance from the fixed end of the vibration plate 50 to the laminated piezoelectric element 10 is more preferably 0.15 × L or greater and yet more preferably 0.2 × L or greater in that a higher sound pressure, that is, a higher displacement amount of the vibration plate 50 can be obtained.

On the other hand, in a case where the position of the laminated piezoelectric element 10 is excessively far from the fixed end of the vibration plate 50, there are the following disadvantages: the laminated piezoelectric element 10 of a required size cannot be cemented to the vibration plate 50; the required number of laminated piezoelectric elements 10 cannot be cemented to the vibration plate 50; multi-channel reproduction such as stereo reproduction is difficult; and the distance between the laminated piezoelectric elements 10 is excessively close and cross talk may occur in a case where the number of channels is increased.

In consideration of this point, the distance from the fixed end of the vibration plate 50 to the laminated piezoelectric element 10 is preferably 0.4 × L or less, and more preferably 0.3 × L or less.

The effect of fixing the vibration plate 50 on the vibration of the vibration plate depends on the rigidity of the vibration plate 50, and the higher the rigidity of the vibration plate 50, the greater the effect. That is, the effect of separating the fixed position of the laminated piezoelectric element 10 from the fixed end of the vibration plate 50 can be obtained more in a case where the rigidity of the vibration plate 50 is high.

In consideration of this point, the two facing sides of the quadrangular vibration plate 50 are fixed, and the laminated piezoelectric element 10 may be cemented to the vibration plate 50 at a distance of 0.1 × L or greater from the fixed end of the vibration plate 50. In such a case, it is preferable that the rigidity of the vibration plate 50 is high to some extent.

Specifically, in a case where the two facing sides of the vibration plate 50 are fixed and the fixed position of the laminated piezoelectric element 10 is separated by 0.1 × L or greater from the fixed end of the vibration plate 50, the spring constant of the vibration plate 50 is preferably equal to or greater than about 1 × 10⁴ N/m and equal to or less than about 1 × 10⁷ N/m, and more preferably equal to or greater than about 1 × 10⁵ N/m and equal to or less than about 1 × 10⁶ N/m. The spring constant of a plate-like member such as a vibration plate can be calculated by multiplying the Young's modulus of the forming material by the thickness of the plate-like member.

In the present invention, the shape of the vibration plate is not limited to rectangles and squares, and it is possible to use various shaped quadrangles such as rhombuses, trapezoids, and parallelograms.

In such a case, as conceptually shown by exemplifying the vibration plate 50a in Fig. 28, the distance L between the fixed ends is set as in L1, L2, L3... at various positions in the separation direction of the other facing sides between the two facing sides fixed by the fixing unit 70.

Further, the cementing position of the laminated piezoelectric element 10 on the vibration plate 50a may be determined such that the laminated piezoelectric element 10 is separated by 0.1 × L1 or greater from the fixed end at a position where the distance between the fixed ends is L1, the laminated piezoelectric element 10 is separated by 0.1 × L2 or greater from the fixed end at a position where the distance between the fixed ends is L2, the laminated piezoelectric element 10 is separated by 0.1 × L3 or greater from the fixed end at the position where the distance between the fixed ends is L3 ....

In the electroacoustic transducer of the present invention, the quadrangle of the vibration plate 50, particularly, the rectangle and the square is not limited to a perfect quadrangle.

Consequently, in the present invention, the quadrangular vibration plate 50 may have a chamfered corner portion, a curved (R-shaped, round) corner portion, or an oval corner portion.

Further, in the electroacoustic transducer of the present invention, the fixing of the two facing sides in the quadrangular vibration plate is not limited to the entire region of the side, and partial regions of the sides may be fixed in accordance with the rigidity of the vibration plate, the size of the vibration plate, and the like.

In such a case, it is preferable to fix a region of 50% or greater of one side, it is more preferable to fix a region of 70% or greater of one side, it is yet more preferable to fix a region of 90% or greater of one side, and it is particularly preferable to fix the entire region of one side.

Further, as described above, in a case where the corner portions of the quadrangle are chamfered or curved, the region not chamfered may be the entire region of one side, or may be the entire region of one side including the chamfered region.

In the electroacoustic transducer of the present invention, the shape of the vibration plate is not limited to a quadrangle, and it is possible to use vibration plates having various shapes such as a circle, an ellipse, and a polygon other than the quadrangle.

Here, in a case where the vibration plate is fixed, high sound pressure or the like can be obtained by cementing the laminated piezoelectric element 10 to the vibration plate at a certain distance from the fixed end of the vibration plate. This preferable effect can also be obtained similarly using various vibration plates other than the quadrangular vibration plate, regardless of the shape of the vibration plate.

For example, in a case where the vibration plate has a polygonal shape having facing sides such as a hexagon and an octagon, it is preferable that the two facing sides are fixed, the distance L between the fixed ends is set as in the quadrangular vibration plate 50, and the laminated piezoelectric element 10 is cemented to the vibration plate 50 at the distance of 0.1 × L or greater from the fixed end.

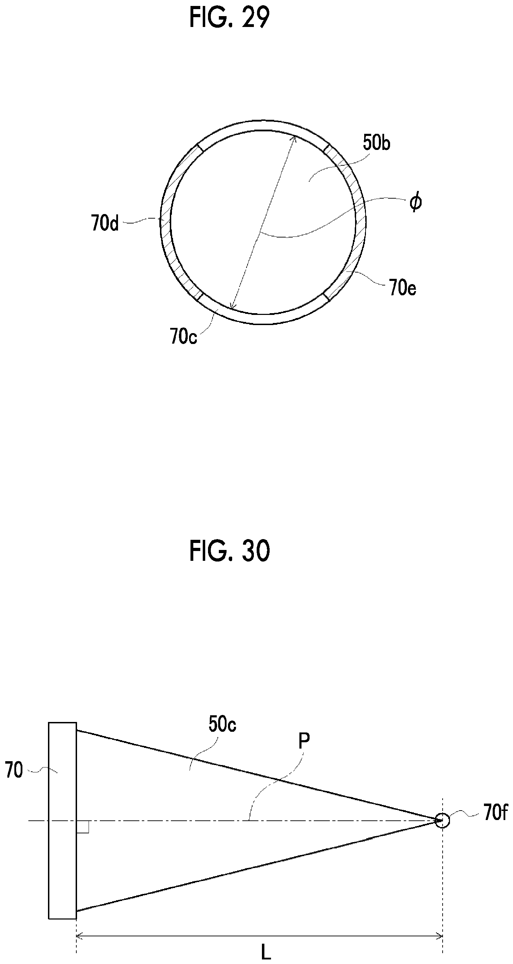

Further, in the case of the circular vibration plate 50b as conceptually shown in Fig. 29, it is conceivable to provide a circular (annular) fixing unit 70c so as to surround the entire circumference of the vibration plate 50b. In such a case, the inside of the fixing unit 70c is the fixed end. Therefore, the inner diameter ϕ of the fixing unit 70c is set as the distance L between the fixed ends, and the laminated piezoelectric element 10 may be cemented at a position separated by 0.1 × L or greater from the fixed end of the vibration plate 50.

Further, in the circular vibration plate 50b as shown in Fig. 29, it is also conceivable that the vibration plate 50b is fixed by an arc-shaped fixing unit such as the fixing unit 70d and the fixing unit 70e which are overlapped with the annular fixing unit 70c in Fig. 29 and indicated by the hatch. In a similar manner, in such a case as well, the laminated piezoelectric element 10 may be cemented at a position separated by 0.1 × L or greater from the fixed end of the vibration plate 50b, where the inner diameter ϕ of the arc of the fixing unit is the distance L between the fixed ends.

The vibration plate may be a polygon with no facing sides, such as a triangle or a pentagon. In such a case, it is conceivable to fix one side of the polygon and the opposite vertices.

For example, as conceptually shown in Fig. 30, in a case where the vibration plate 50c is a triangle, it is conceivable to fix one side of the triangle with the fixing unit 70 and fix the vertex facing the one side with the fixing unit 70f.

In such a case, the vertical line P is drawn from the vertex fixed by the fixing unit 70f to the opposite side to be fixed, and the distance of the vertical line from the vertex to the fixed side is set as the distance L between the fixed ends, and the laminated piezoelectric element 10 may be cemented to a position separated from the fixed end (one of which is the vertex) of the vibration plate 50c by 0.1 × L or greater.

The position where the piezoelectric element acting as an exciter is cemented to the vibration plate is set in the same manner, in a case where the piezoelectric element acting as an exciter is constituted of one piece of piezoelectric film, and in a case where the piezoelectric element acting as an exciter is a laminated piezoelectric element in which a cut sheet-shaped piezoelectric film is laminated and preferably an adjacent piezoelectric film is cemented.

By the way, as in the present invention, a laminated piezoelectric element in which a plurality of piezoelectric films are laminated by folding back one piezoelectric film can be considered to have two configurations.

The first configuration is a configuration in which the bent portion of the piezoelectric film due to folding back is along the longitudinal direction of the laminated piezoelectric element. That is, the first configuration is a configuration in which the bent portion of the piezoelectric film due to folding back coincides with the longitudinal direction of the laminated piezoelectric element.

The second configuration is a configuration in which the bent portion of the piezoelectric film due to folding back is along the lateral direction of the laminated piezoelectric element. That is, the second configuration is a configuration in which the bent portion of the piezoelectric film due to folding back coincides with the lateral direction of the laminated piezoelectric element.

In other words, the laminated piezoelectric element in which the piezoelectric film is folded back and laminated can be considered to have a configuration in which a ridge line formed by folding back the piezoelectric film coincides with the longitudinal direction of the laminated piezoelectric element and a configuration in which the ridge line coincides with the lateral direction of the laminated piezoelectric element.

The longitudinal direction and the lateral direction of the laminated piezoelectric element are specifically the longitudinal direction and the lateral direction in the planar shape of the laminated piezoelectric element observed in the lamination direction of the piezoelectric film 12.

The planar shape of the laminated piezoelectric element observed in the lamination direction of the piezoelectric film 12 is, in other words, a shape in a case where the laminated piezoelectric element is observed from a direction orthogonal to the principal surface of the piezoelectric film 12.

Specifically, in a case where five layers of the piezoelectric film are laminated by folding back one piezoelectric film to produce a 20 × 5 cm laminated piezoelectric element, the following two configurations can be considered.

In the laminated piezoelectric element shown below, in order to simplify the drawing, the change in the thickness at the folded-back portion is not repeated, and the thickness of the piezoelectric film 12 to be folded back and laminated in a plurality of layers is shown uniformly.

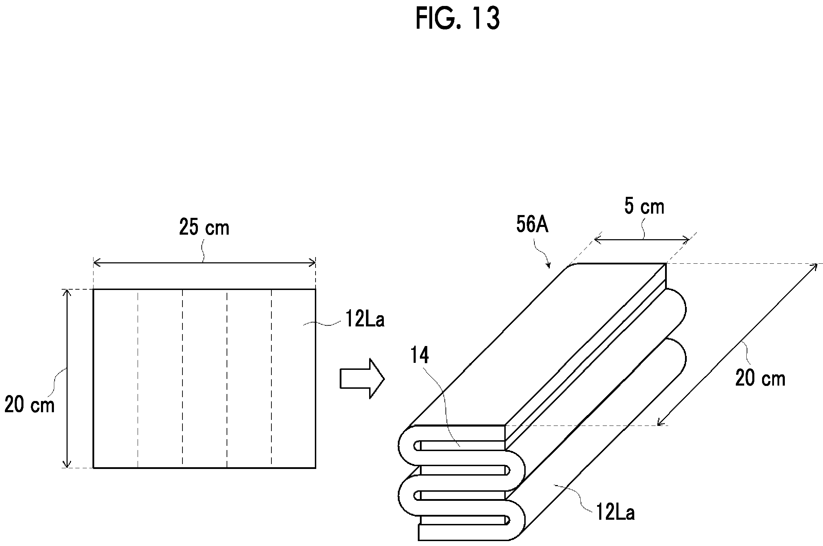

As conceptually shown in Fig. 13, the first configuration is a laminated piezoelectric element 56A in which five layers of the piezoelectric film 12La are laminated by folding back a rectangular piezoelectric film 12La of 20 × 25 cm four times by 5 cm at a time in the direction of 25 cm. In the laminated piezoelectric element 56A, the bent portion of the piezoelectric film 12La due to folding back is along the direction of 20 cm, which is the longitudinal direction of the laminated piezoelectric element 56A. That is, in the laminated piezoelectric element 56A, a ridge line formed by folding back the piezoelectric film 12La coincides with the longitudinal direction of the laminated piezoelectric element 56A.

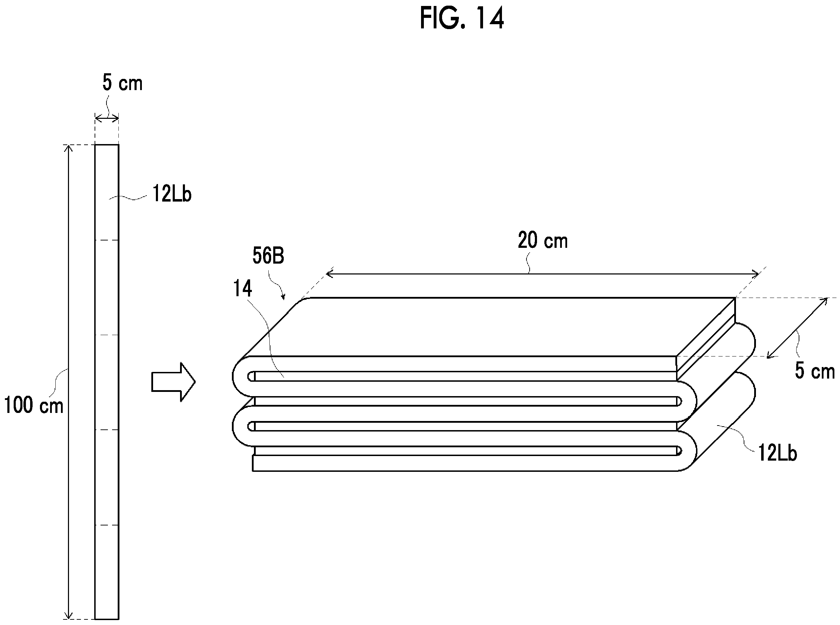

As conceptually shown in Fig. 14, the second configuration is a laminated piezoelectric element 56B in which five layers of the piezoelectric film 12Lb are laminated by folding back a rectangular piezoelectric film 12Lb of 100 × 5 cm four times by 20 cm at a time in the direction of 100 cm. In the laminated piezoelectric element 56B, the bent portion of the piezoelectric film 12Lb due to folding back is along the direction of 5 cm, which is the lateral direction of the laminated piezoelectric element 56B. That is, in the laminated piezoelectric element 56B, a ridge line formed by folding back the piezoelectric film 12Lb coincides with the lateral direction of the laminated piezoelectric element 56B.

In the present invention, the laminated piezoelectric element in which the piezoelectric films are folded back and laminated is able to suitably employ a configuration in which the bent portion due to the folding back of the piezoelectric film is along the longitudinal direction of the laminated piezoelectric element or a configuration in which the laminated piezoelectric element is oriented in the lateral direction.

That is, there are advantages in the configuration in which the bent portion of the piezoelectric film due to folding back is along the longitudinal direction of the laminated piezoelectric element and the configuration in which the bent portion is along the lateral direction. Accordingly, which configuration to employ may be appropriately set according to application of the laminated piezoelectric element and the like.

Further, the laminated piezoelectric element may be provided with lead-out wiring lines connected to the first electrode 24 and the second electrode 26 to reach the outside of the laminated piezoelectric element in order to connect to an external device such as a power source device. It should be noted that each lead-out wiring line does not necessarily have to physically protrude to the outside, which means that the lead-out wiring line is electrically drawn out from the electrode.

The lead-out wiring line can be formed by using the method described above. For example, the lead-out wiring line is provided at the end part of the piezoelectric film or in a region protruding to the outside by exposing the first electrode 24 and the second electrode 26 and connecting them here without providing the piezoelectric layer 20. As another example, the lead-out wiring line is provided such that the protective film and the electrode layer are peeled off at the end part of the piezoelectric film or the region protruding to the outside and a copper foil tape or the like is inserted between the piezoelectric layer 20 and the electrode layer. As yet another example, the lead-out wiring line is provided in a state where a through-hole is provided in the protective layer of the piezoelectric film at the end part of the piezoelectric film or a region protruding to the outside, a conductive member is formed using a conductive member such as silver paste in the through-hole, and a copper foil tape or the like is connected to this conductive member.

Here, the piezoelectric layer 20 of the piezoelectric film 12 has a preferable thickness of 8 to 300 µm and is extremely thin. Therefore, in order to prevent a short circuit, it is preferable to provide the lead-out wiring lines at different positions in the plane direction of the piezoelectric film. That is, it is preferable that the lead-out wiring lines are provided so as to be offset in the plane direction of the piezoelectric film.

In the laminated piezoelectric element of the present invention, it is preferable that the piezoelectric film 12 is provided with the protruding portion protruding from the laminated piezoelectric element, and the lead-out wiring lines are connected to the protruding portion.

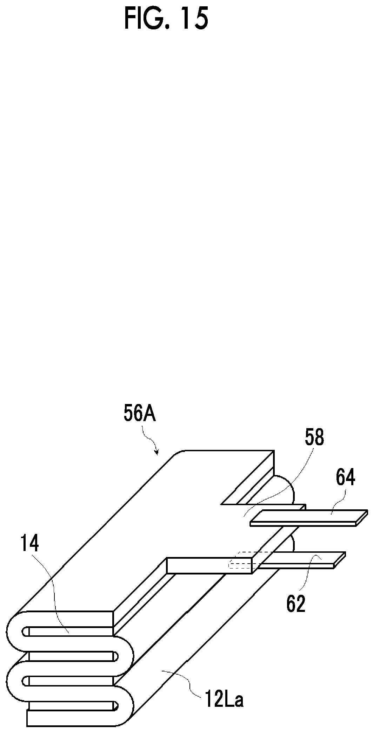

For example, in a case where the bent portion of the piezoelectric film 12La due to folding back is a laminated piezoelectric element 56A along the longitudinal direction, a dock-shaped protruding portion 58 may be provided at one end part in the folding-back direction, as conceptually shown in Fig. 15, and the lead-out wiring line 62 and the lead-out wiring line 64 may be connected to the protruding portion.

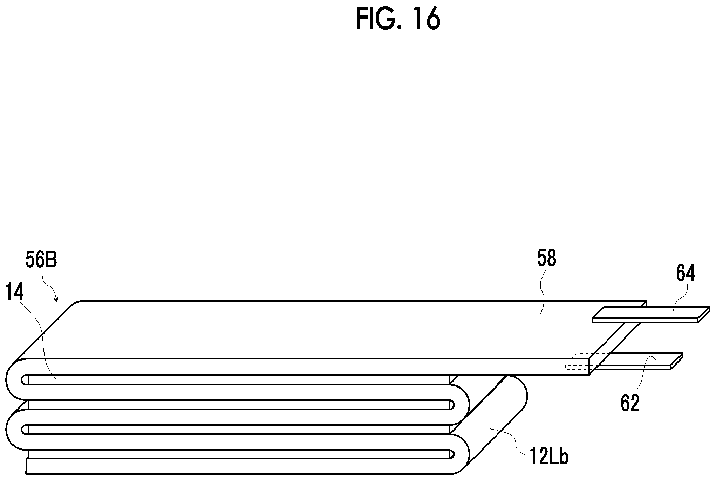

Further, in a case where the bent portion of the piezoelectric film 12Lb due to folding back is a laminated piezoelectric element 56B along the lateral direction, one end part in the folding-back direction may be extended to form the protruding portion 58 as conceptually shown in Fig. 16, and the lead-out wiring line 62 and the lead-out wiring line 64 may be connected to the protruding portion.

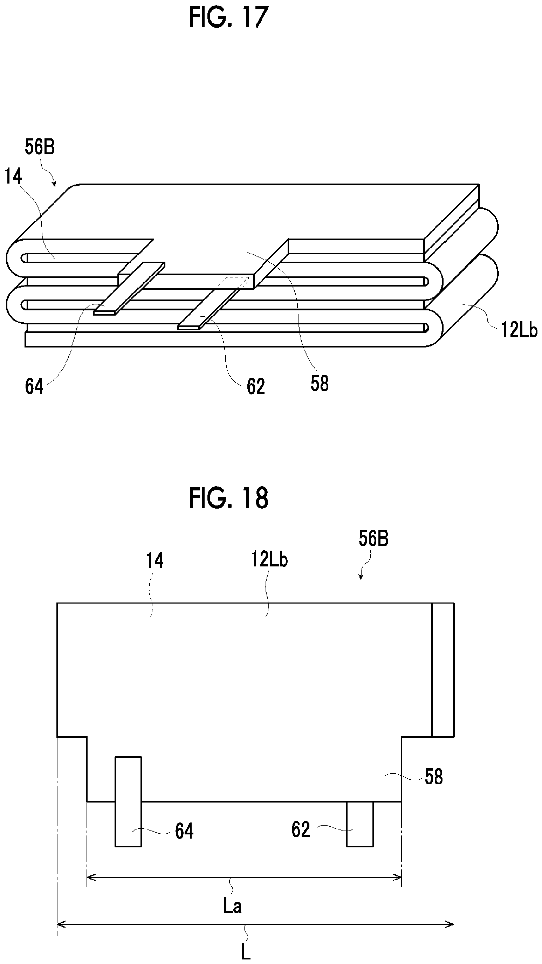

Further, in a case where the bent portion of the piezoelectric film 12Lb due to folding back is the laminated piezoelectric element 56B along the lateral direction, as conceptually shown in Fig. 17, the dock-shaped protruding portion 58 may be provided at the end part in the direction orthogonal to the folding-back direction, that is, the end part of the piezoelectric film 12Lb in the longitudinal direction, and the lead-out wiring line 62 and the lead-out wiring line 64 may be connected to the protruding portion.

Here, in the laminated piezoelectric element of the present invention, it is preferable that the protruding portion of the piezoelectric film protrudes from the end part in the longitudinal direction of the laminated piezoelectric element, and the length of the protruding portion 58 in the longitudinal direction of the laminated piezoelectric element is equal to or greater than 10% of the length of the laminated piezoelectric element in the longitudinal direction of the element.

In the following description, the length of the protruding portion of the laminated piezoelectric element in the longitudinal direction is also simply referred to as "the length of the protruding portion".

In the laminated piezoelectric element of the present invention, in a case where the protruding portion 58 protrudes from the end part in the lateral direction of the laminated piezoelectric element, it is preferable that the length of the protruding portion 58 in the lateral direction is equal to or greater than 50% of the length of the laminated piezoelectric element in the lateral direction.

This will be specifically described with reference to the conceptual diagram of the laminated piezoelectric element 56B of Fig. 18.

The laminated piezoelectric element 56B is a laminated piezoelectric element in which the bent portion of the piezoelectric film 12Lb due to folding back is along the lateral direction of the laminated piezoelectric element (refer to Figs. 14 and 17). Accordingly, as shown in Fig. 18, the longitudinal direction of the laminated piezoelectric element 56B is a direction orthogonal to the folding-back direction of the piezoelectric film 12La. That is, the longitudinal direction of the laminated piezoelectric element 56B coincides with a longitudinal direction of the piezoelectric film 12La.

As shown in Fig. 18, the length of the laminated piezoelectric element 56B in the longitudinal direction is set as L. In the present invention, it is preferable that the protruding portion 58 has a length L of 10% or more of the length La in the longitudinal direction, that is, "La ≥ L/10".

Thereby, the current density in the path through which the drive current flows from the lead-out wiring line to the laminated piezoelectric element can be reduced. Therefore, the voltage drop can be reduced and the piezoelectric characteristics can be improved. For example, the above-mentioned electroacoustic transducer is able to improve the sound pressure.

The length La of the protruding portion 58 is more preferably 50% or more, further preferably 70% or more, particularly preferably 90% or more of the length L of the laminated piezoelectric element in the longitudinal direction, and most preferably equal to or greater than the length of the planar shape of the laminated piezoelectric element 56B in the longitudinal direction.

Accordingly, in the case where the bent portion of the piezoelectric film 12La shown in Figs. 13 and 15 due to folding back is the laminated piezoelectric element 56A along the longitudinal direction, as in the laminated piezoelectric element 56B shown in Fig. 16, it is preferable that the protruding portion is formed by extending one end part in the folding-back direction and the lead-out wiring line 62 and the lead-out wiring line 64 are connected to the protruding portion. In such a case, the length La of the protruding portion coincides with the length L of the laminated piezoelectric element in the longitudinal direction. That is, in such a case, the protruding portion covers the entire area in the longitudinal direction of the laminated piezoelectric element.

The protruding portion 58 may be provided on any layer of the piezoelectric films that are folded back and laminated, but is preferably provided on the uppermost layer or the lowermost layer in terms of piezoelectric efficiency and the like.

Further, the protruding portions may be provided in a plurality of layers such as the uppermost layer and the lowermost layer of the piezoelectric film, and the uppermost layer and the intermediate layer and the lowermost layer, or may be provided in all the layers of the piezoelectric film. In a case where the protruding portions 58 are provided in a plurality of layers of the piezoelectric film, all of the protruding portions 58 may be provided at the end part in the lateral direction of the laminated piezoelectric element, or all of the protruding portions 58 may be provided at the end part in the longitudinal direction. Alternatively, the protruding portions 58 at the end part in the lateral direction and the protruding portion 58 at the end part in the longitudinal directions may be mixed.

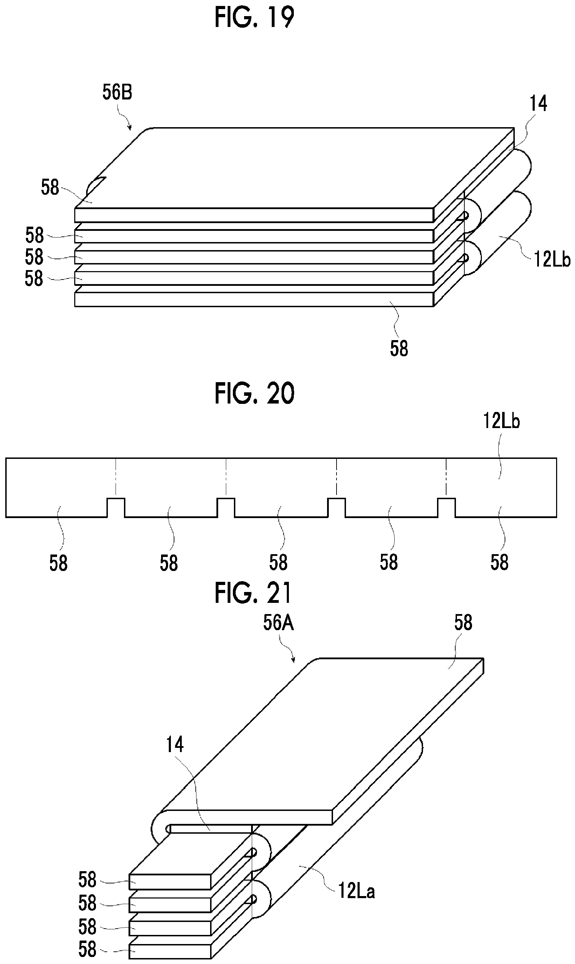

For example, as exemplified by the laminated piezoelectric element 56B in Fig. 19, the five layers of the laminated piezoelectric film 12Lb, and the protruding portions 58 may be provided so as to protrude from the end parts of all the layers in the longitudinal direction.

For example, such a laminated piezoelectric element 56B may be manufactured by using the piezoelectric film 12Lb provided with a protruding portion 58 in accordance with a folded-back portion (dashed-dotted line) as shown in Fig. 20.

In the piezoelectric film 12Lb as shown in Fig. 20, two or more protruding portions 58, particularly all the protruding portions 58, may be connected and provided. At this time, the protruding portion 58 is a part that protrudes from the cementing layer 14 at the end part in the longitudinal direction of the laminated piezoelectric element 56B. In this regard, the same applies to the laminated piezoelectric element 56A shown in Fig. 21, which will be described later.

As another example, as exemplified by the laminated piezoelectric element 56A in Fig. 21, in the uppermost layer in the drawing, the protruding portion 58 may be provided by extending the piezoelectric film 12La in the folding-back direction and protruding from the end part of the laminated piezoelectric element 56A in the longitudinal direction. Then, the second layer, the third layer surface, the fourth layer, and the lowermost layer may be provided with the protruding portions 58 protruding from the end parts of the laminated piezoelectric element 56A in the lateral direction.

In such a configuration, for example, the second layer, the third layer surface, and the fourth layer may be provided with the protruding portions 58 protruding from the end parts of the laminated piezoelectric element 56A in the lateral direction. In addition, as in the uppermost layer, the lowermost layer may also be provided with the protruding portion 58 protruding from the end part of the laminated piezoelectric element 56A in the longitudinal direction by extending the piezoelectric film 12La in the folding-back direction.

While the laminated piezoelectric element and the electroacoustic transducer of the present invention have been described in detail, the present invention is not limited to the examples described above, and various improvements or modifications may be naturally performed within a range not deviating from the gist of the present invention.

The laminated piezoelectric element can be suitably used as an exciter or the like that abuts on various members to generate a sound.

### Explanation of References

10, 10A, 56A, 56B: laminated piezoelectric element
12, 12La, 12Lb: piezoelectric film
12a, 12c: sheet-like member
12b: laminate
14, 52: cementing layer
16: power source
20: piezoelectric layer
24: first (thin film) electrode
26: second (thin film) electrode
28: first protective layer
30: second protective layer
34: matrix
36: piezoelectric particles
40: folded-back portion
40a: air gap
42: rod-like body
46: roller
50, 50a, 50b, 50c: vibration plate
58: protruding portion
62,64: lead-out wiring line
70, 70a, 70b, 70c, 70d, 70e, 70f: fixing unit

## Claims

1. A laminated piezoelectric element formed by folding back and laminating a piezoelectric film having a piezoelectric layer including piezoelectric particles in a matrix including a polymer material, electrode layers provided on both sides of the piezoelectric layer, and a protective layer provided to cover the electrode layer,
wherein in adjacent two layers of the piezoelectric film folded back and laminated, in a case where a thickness of a central portion in a folding-back direction is a center thickness, a length from an end part of a folded-back portion to the central portion in the folding-back direction is L, and a region of 1/3 of the length L from the end part of the folded-back portion to the central portion in the folding-back direction is set as the folded-back portion, the folded-back portion has a part of which a thickness is greater than the center thickness, and
an air gap is provided between adjacent two layers of the piezoelectric film in the folded-back portion, or a space between the adjacent two layers of the piezoelectric film is filled with a cementing agent.

2. The laminated piezoelectric element according to claim 1, comprising a cementing layer to which adjacent two layers of the piezoelectric films folded back and laminated are cemented.

3. The laminated piezoelectric element according to claim 1 or 2, wherein the piezoelectric film is folded back and laminated a plurality of times.

4. The laminated piezoelectric element according to any one of claims 1 to 3, wherein positions of outer end parts of the folded-back portions adjacent in a lamination direction are different in the folding-back direction of the piezoelectric film.

5. The laminated piezoelectric element according to any one of claims 1 to 4, wherein the piezoelectric film is polarized in a thickness direction.

6. The laminated piezoelectric element according to any one of claims 1 to 5, wherein the polymer material of the piezoelectric layer is a polymer material having a cyanoethyl group.

7. The laminated piezoelectric element according to claim 6, wherein the polymer material is cyanoethylated polyvinyl alcohol.

8. The laminated piezoelectric element according to any one of claims 1 to 7, comprising a protruding portion from which the piezoelectric film protrudes at an end part of the laminated piezoelectric element in a longitudinal direction,
wherein a length of the protruding portion in the longitudinal direction is 10% or more of a total length in the longitudinal direction.

9. An electroacoustic transducer comprising: the laminated piezoelectric element according to any one of claims 1 to 8; and a vibration plate to which the laminated piezoelectric element is fixed.

10. The electroacoustic transducer according to claim 9, wherein the vibration plate is flexible.

11. The electroacoustic transducer according to claim 9 or 10, wherein the vibration plate and the laminated piezoelectric element are cemented by a cementing agent.

12. The electroacoustic transducer according to claim 11, wherein the vibration plate has a quadrangular shape of which at least one group of two facing sides is fixed, and in a case where a distance between fixed ends of the two facing sides is L, cementing of the laminated piezoelectric element to the vibration plate is performed at positions separated from the fixed ends by "0.1 × L" or greater.

13. The electroacoustic transducer according to claim 12, wherein the vibration plate has a rectangular shape or a square shape.

14. The electroacoustic transducer according to claim 12 or 13, wherein a spring constant of the vibration plate is equal to or greater than 1 × 10⁴ N/m and equal to or less than 1 × 10⁷ N/m.
